# EUROPEAN PATENT APPLICATION

(11) **EP 4 593 552 A1**
(43) Date of publication of application: **30.07.2025**
(21) Application number: 24200952.0
(22) Date of filing: 18.09.2024
(51) Int. Cl.: H10D 62/17, H10D 30/01, H10D 30/83, H10D 64/27, H10D 84/00, H10D 84/80

(54) **VERTICAL TRENCH-GATE JUNCTION-GATE FIELD-EFFECT TRANSISTOR WIT AN INTEGRAL COUPLING CAPACITANCE GATED CONTACT AND MANUFACTURING METHOD THEREOF**

(30) Priority: 24.01.2024 CN 202410097602
(71) Applicant: Suzhou Watech Electronics Co., Ltd., Suzhou, Jiangsu 215125 (CN)
(72) Inventor: ZHANG, Xiaoyu, Suzhou, Jiangsu, 215125 (CN); YUE, Dancheng, Suzhou, Jiangsu, 215125 (CN); WANG, Changchang, Suzhou, Jiangsu, 215125 (CN)
(74) Representative: Michalski Hüttermann & Partner Patentanwälte mbB

(57) **Abstract**

Disclosed are a vertical trench gate junction field effect transistor (JFET) with a coupling capacitance in series with the gate, and a manufacturing method thereof. The vertical trench-gate junction field effect transistor includes a substrate (1) of a first doping type, an epitaxial layer (2) of the first doping type, and a plurality of repeating units disposed adjacently; where the epitaxial layer (2) is disposed on the substrate (1), the substrate serves as a drain region, and each of the repeating units includes: two source regions (4) of the first doping type; a trench (6, 7, 8); a semiconductor gate (6) of the second doping type opposite the first conductivity type; a dielectric (7); and a coupling capacitance upper electrode (8), wherein the gate (6) forms the coupling capacitance lower electrode and is indirectly controlled by the coupling capacitance upper electrode (8) spaced from the gate (6) by the dielectric layer (7).

## Description

### TECHNICAL FIELD

The present disclosure relates to the technical field of semiconductor devices, and more particularly to a vertical trench coupling capacitance gate-controlled junction field effect transistor and a manufacturing method thereof.

### BACKGROUND

Silicon carbide (SiC) material is a three-generation wide band gap semiconductor material, the band gap of SiC is much higher than traditional silicon material (1.1 eV), the critical breakdown field strength of SiC is an order of magnitude higher than silicon material, SiC material has the advantage of bearing high temperature and high voltage, and the saturation drift velocity of SiC material is fast, SiC material is suitable for the manufacturing power semiconductor device with fast response and capable of bearing high temperature and high voltage, such as a vertical double-diffused MOSFET(VDMOS), a junction field-effect transistor (JFET) and so on.

The junction field effect transistor (JFET) is a three-port semiconductor device. The operating principle of the JEFT is controlling the reverse bias of the PN junction formed between the gate electrode and the channel by the voltage applied to the gate to realize the on-off of the drain electrode and the source electrode. In a case where no voltage is not applied to the gate electrode, the JEFT is usually a normally-on device, and the conducted channel is inside the device. The JFET has the advantages of low noise, small size, and high-frequency response, often being applied to switching devices, power amplifiers, and digital electronic circuits to satisfy the requirements of different electronic devices.

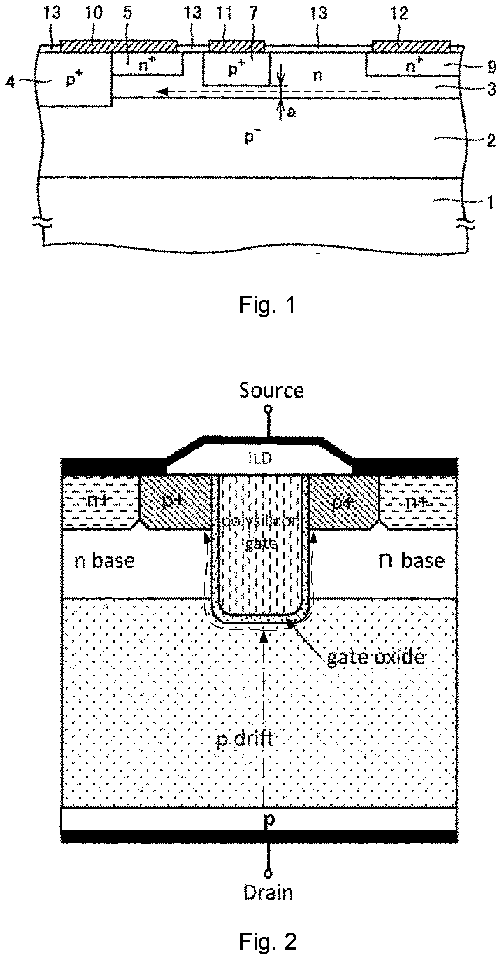

A JFET device according to patent No. CN1238904C, as shown in Fig. 1, comprises a monocrystalline silicon (SiC) substrate 1, a p- type epitaxial layer 2, an n- type epitaxial layer 3, a p+ type semiconductor layer 4, an n+ type source region layer 5, a p+ type gate layer 7, an n+ type drain region layer 9, a source electrode 10, a gate electrode 11, a drain electrode 12. The conducted channel of the JFET device is located inside the device, and inside the n-type epitaxial layer 3. The conducted channel disposed inside the semiconductor material can avoid the problem of low mobility in the SiC material surface. Due to the JFET device being a normally-on device, that is, in the case where no voltage is applied to the p+ gate layer 7 (i.e., gate electrode), the device is conducted (the current is represented by the dotted line in Fig. 1), and a voltage must be applied to the p+ type gate layer 7 (i.e., gate electrode) to turn off the device, which is limited the application as a power switch. The structure of the P+ type gate layer 7 (i.e., the gate electrode) and the channel forming a PN junction, and a voltage higher than 3V cannot be applied to the P+ type gate layer 7 (i.e., the gate electrode). For SiC material, a voltage of 3V or more is applied to the gate electrode, the gate electrode and the channel are conducted or the gate electrode and the source electrode are conducted, and the conducting current strongly affects the current characteristic from the drain electrode to the source electrode. The gate electrode cannot be applied to a high voltage, which limits the application as a power switch.

Therefore, the conventional JEFT device has technical problems in that the gate electrode cannot be applied to a higher voltage and has a low reliability limiting the application as a power switch.

The above information disclosed in the background is only for enhancing the understanding of the background of the present disclosure and thus may contain information that does not form the prior art known to one having ordinary skills in the art.

### SUMMARY

The embodiments of the present disclosure provided a vertical trench coupling capacitance gate-controlled junction field effect transistor and a manufacturing method thereof to solve the problems in the conventional JFET device that the gate electrode cannot be applied to a higher voltage and has low reliability limiting the application as a power switch.

According to the first aspect of the embodiment of the disclosure, a vertical trench coupling capacitance gate-controlled junction field effect transistor is provided and comprises a substrate of a first doping type, an epitaxial layer of the first doping type, and a plurality of repeating units, where the epitaxial layer disposed on the substrate, the substrate serves as the drain region, and each of the repeating units comprises:
two source regions of the first doping type, formed inside the epitaxial layer and spaced apart in the lateral direction;
a trench, formed downwardly from an upper surface of the epitaxial layer and disposed between the two source regions of the first doping type;
a gate of a second doping type, formed on an inner wall of the trench and a bottom of the trench; where the gate is in a floating state;
a dielectric layer, at least formed on an inner bottom of the gate; and
a coupling capacitance upper electrode, formed on the dielectric layer.

According to the second aspect of the embodiment of the disclosure, a manufacturing method of the vertical trench coupling capacitance gate-controlled junction field effect transistor is provided and comprises:
forming an epitaxial layer of a first doping type on a substrate of the first doping type; and
forming a plurality of repeating units, further comprising:
forming two source regions of the first doping type inside the epitaxial layer and spaced apart in the lateral direction;
forming a trench downwardly from an upper surface of the epitaxial layer and disposed between the two source regions of the first doping type;
forming a gate of a second doping type on an inner wall of the trench and a bottom of the trench;
at least forming a dielectric layer on the inner bottom of the gate; and
forming a coupling capacitance upper electrode on the dielectric layer.

The gate is indirectly controlled by the coupling capacitance upper electrode spaced with the dielectric layer.

The embodiments of the present disclosure have the following technical advantages due to the adoption of the above technical proposals.

For the vertical trench coupling capacitance gate-controlled junction field effect transistor of the embodiments of the present disclosure, the gate is indirectly controlled by the coupling capacitance upper electrode spaced with the dielectric layer, the coupling capacitance upper electrode voltage applied to the coupling capacitance upper electrode is coupled to the gate by coupling. Since the gate is in a floating state which is not directly connected to the gate electrode, the electric potential of the coupling capacitance upper electrode can be increased to more than 3V without causing the coupling capacitance upper electrode, the substrate and the lower portion of the epitaxial layer located under the gate to conduct. Compared with the JFET device according to patent No. CN1238904C, the transistor of the embodiment of the present disclosure cannot be conducted even if a high voltage (more than 3V, e.g., 4V, 5V) is applied to the coupling capacitance upper electrode, and which does not affect the current characteristic from the drain electrode to the source electrode. The gate is indirectly controlled by the coupling capacitance upper electrode spaced with the dielectric layer so that no current flows through the gate and the reliability is high.

### BRIEF DESCRIPTION OF THE DRAWINGS

The drawings described herein are intended to provide a further understanding of the present disclosure and are incorporated in and constitute a part of this specification, schematic embodiments of the disclosure together with the description serve to explain the principles of the present disclosure, and do not constitute an improper limitation of the present disclosure. In the drawings:
Fig. 1 is a schematic diagram of a conventional L-JFET.
Fig. 2 is a schematic diagram of a conventional Trench VDMOS device.
Fig. 3-1 is a schematic diagram of the first implementation of a vertical trench coupling capacitance gate-controlled junction field effect transistor according to the embodiments of the present disclosure.
Fig. 3-2 is a schematic diagram of the second implementation of a vertical trench coupling capacitance gate-controlled junction field effect transistor according to the present disclosure.
Fig. 3-3 is a schematic diagram of the third implementation of a vertical trench coupling capacitance gate-controlled junction field effect transistor according to the present disclosure.

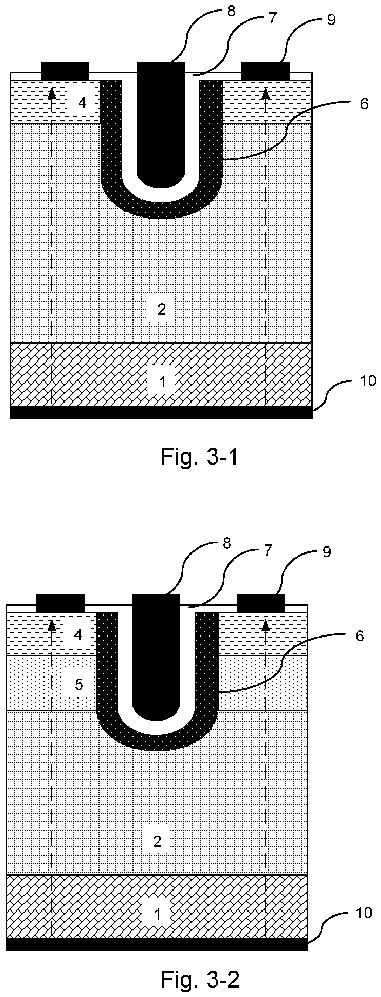

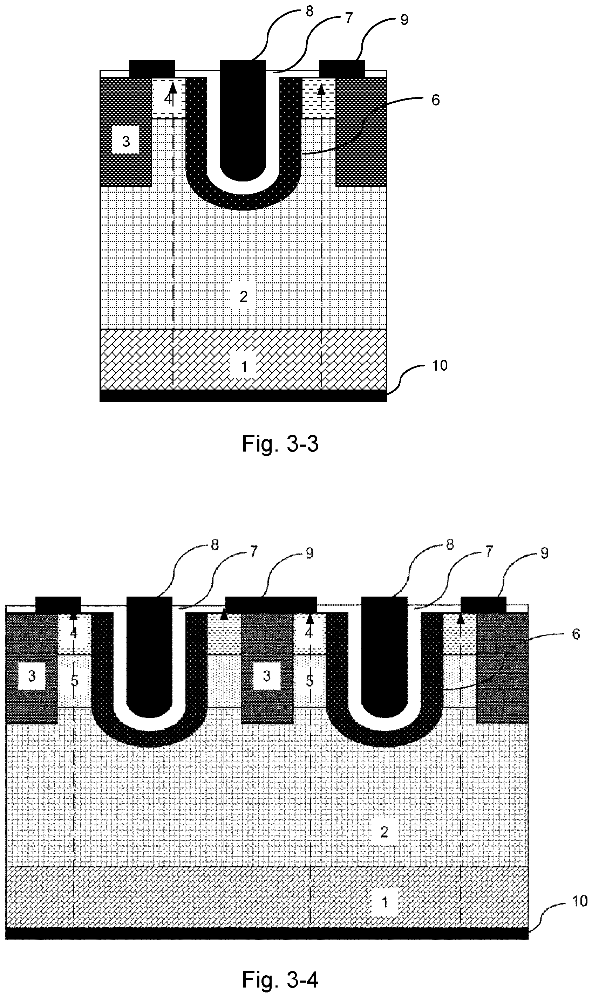

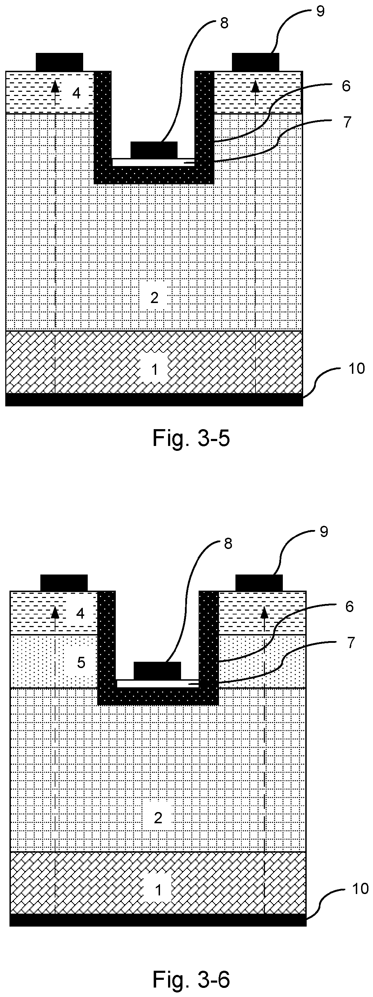

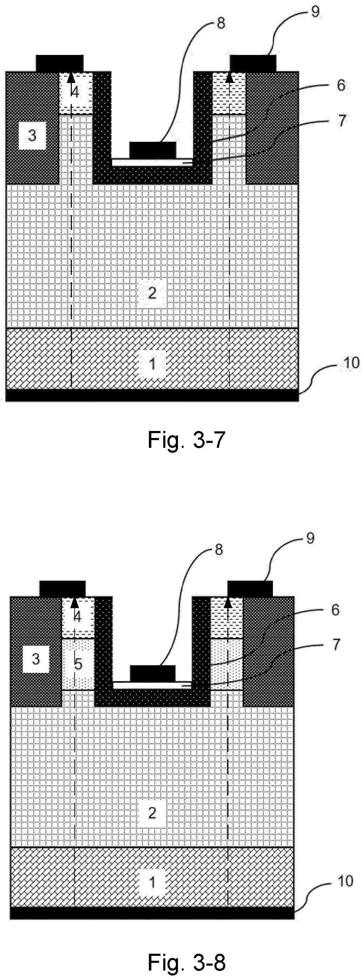

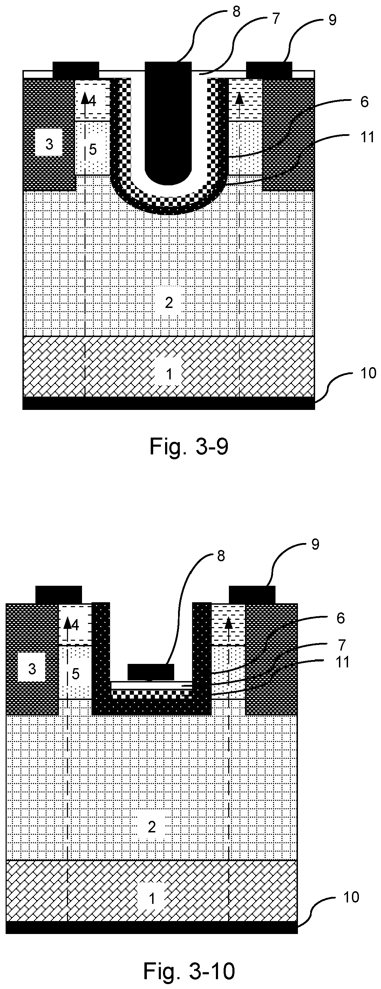

Fig. 3-4 is a schematic diagram of the fourth implementation of a vertical trench coupling capacitance gate-controlled junction field effect transistor according to the present disclosure.
Fig. 3-5 is a schematic diagram of the fifth implementation of a vertical trench coupling capacitance gate-controlled junction field effect transistor according to the present disclosure.
Fig. 3-6 is a schematic diagram of the sixth implementation of a vertical trench coupling capacitance gate-controlled junction field effect transistor according to the present disclosure.
Fig. 3-7 is a schematic diagram of the seventh implementation of a vertical trench coupling capacitance gate-controlled junction field effect transistor according to the present disclosure.
Fig. 3-8 is a schematic diagram of the eighth implementation of a vertical trench coupling capacitance gate-controlled junction field effect transistor according to the present disclosure.
Fig. 3-9 is a schematic diagram of the ninth implementation of a vertical trench coupling capacitance gate-controlled junction field effect transistor according to the present disclosure.
Fig. 3-10 is a schematic diagram of the tenth implementation of a vertical trench coupling capacitance gate-controlled junction field effect transistor according to the present disclosure.

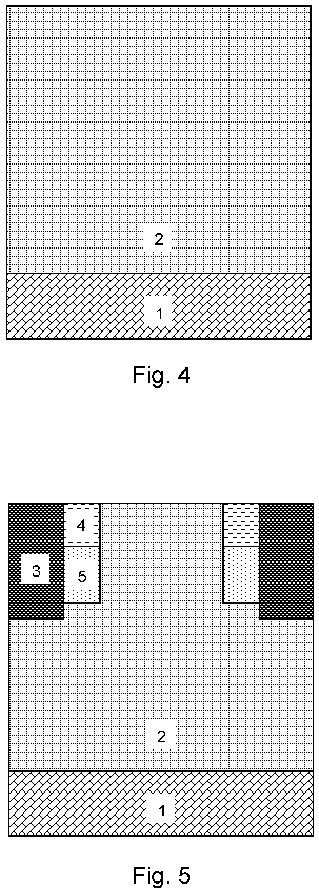

Fig. 4 is a schematic diagram of the manufacturing method of the second implementation of a vertical trench coupling capacitance gate-controlled junction field effect transistor according to the present disclosure, illustrating forming an epitaxial layer on the substrate.
Fig. 5 is a schematic diagram, illustrating forming the second doping type ohmic contact regions, a source region, and a channel based on Fig. 4.

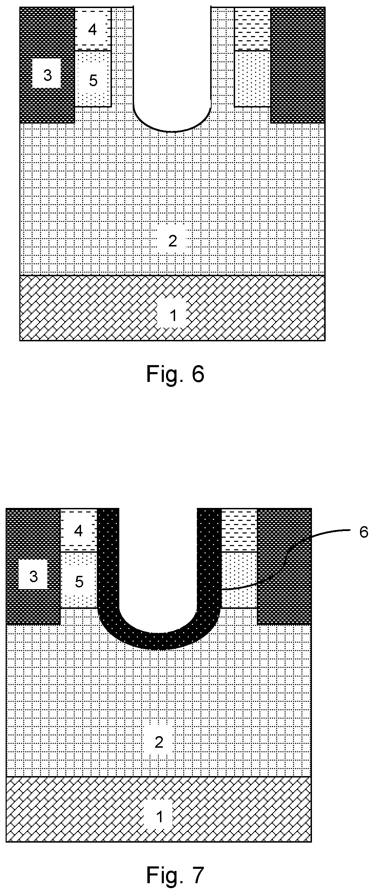

Fig. 6 is a schematic diagram, illustrating forming a trench based on Fig. 5.
Fig. 7 is a schematic diagram, illustrating forming a gate based on Fig. 6.

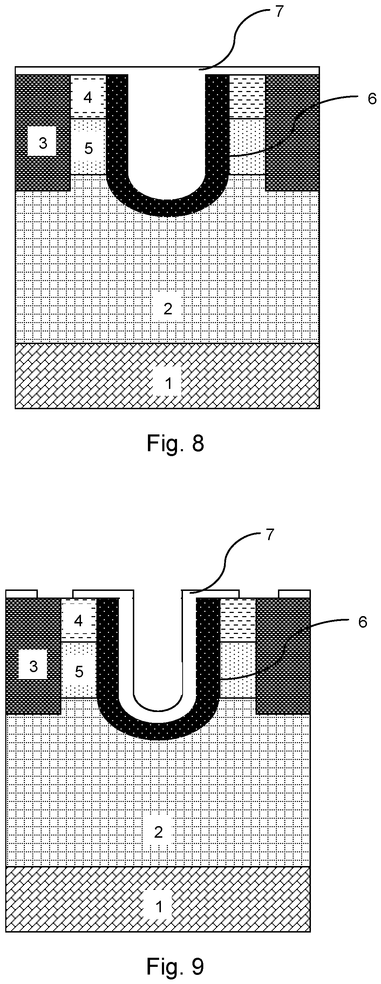

Fig. 8 is a schematic diagram, illustrating forming a dielectric layer based on Fig. 7.
Fig. 9 is a schematic diagram, illustrating reserving locations for a coupling capacitance upper electrode and source electrodes based on Fig. 8.

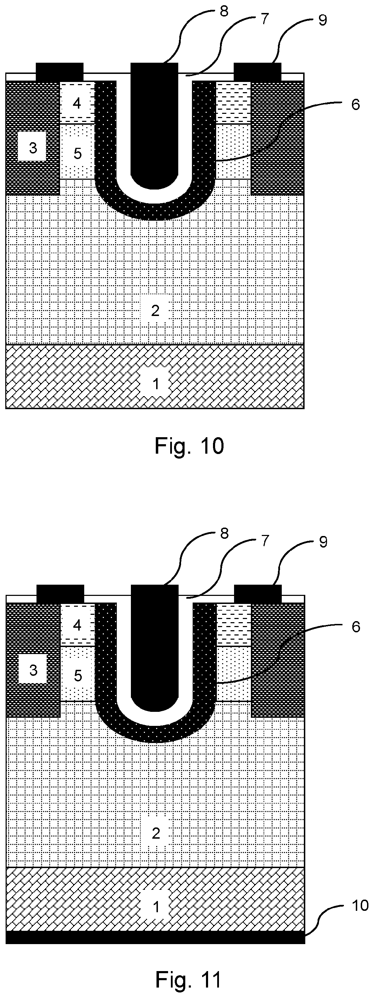

Fig. 10 is a schematic diagram of forming the coupling capacitance upper electrode and the source electrodes based on Fig. 9.
Fig. 11 is a schematic diagram, illustrating forming a drain electrode based on Fig. 10.

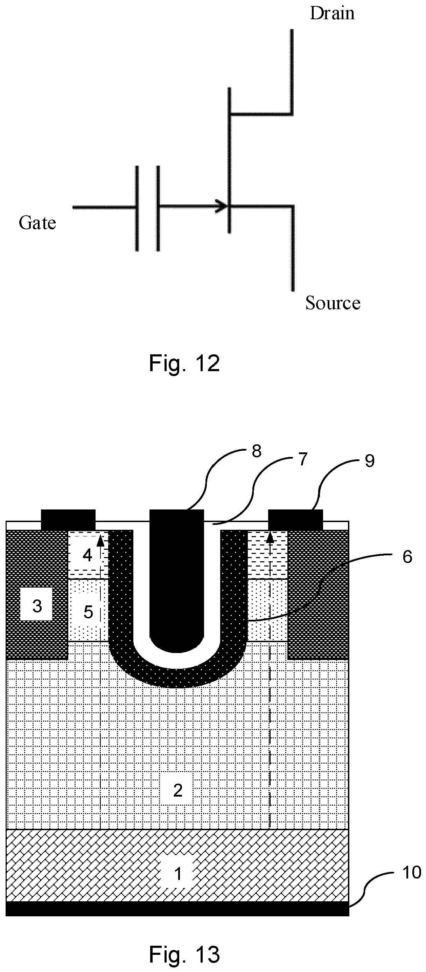

Fig. 12 is an equivalent circuit diagram of the vertical trench coupling capacitance gate-controlled junction field effect transistor according to the embodiment of the present disclosure.
Fig. 13 is a schematic diagram of the vertical trench coupling capacitance gate-controlled junction field effect transistor according to the embodiment of the present disclosure in a conducted state, illustrating a current path.

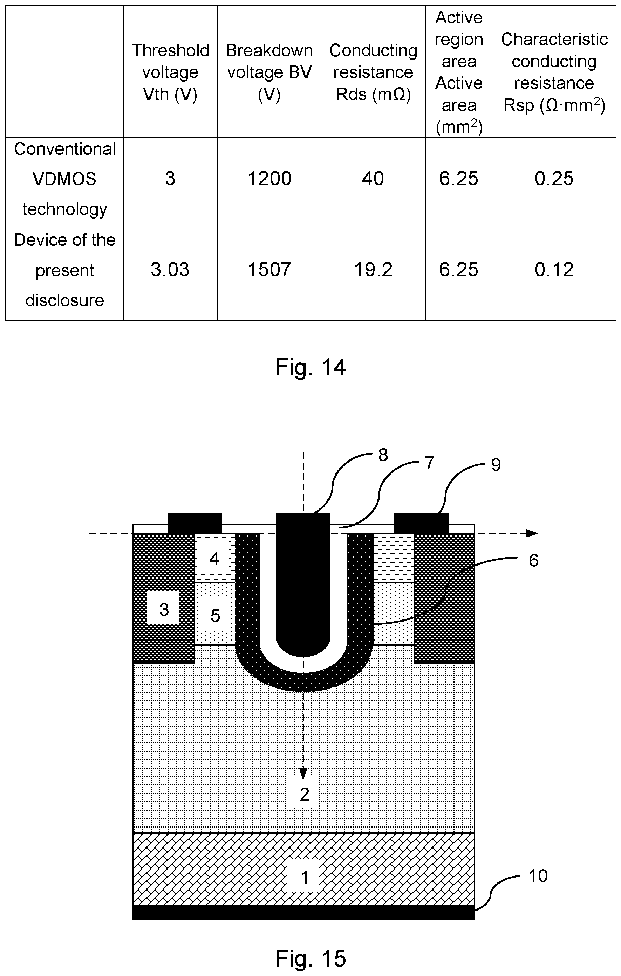

Fig. 14 is a comparison schematic diagram of the characteristics of the vertical trench coupling capacitance gate-controlled junction field effect transistor according to the present disclosure with the characteristics of the conventional VDMOS device.
Fig. 15 is a schematic diagram of the vertical trench coupling capacitance gate-controlled junction field effect transistor according to the present disclosure.

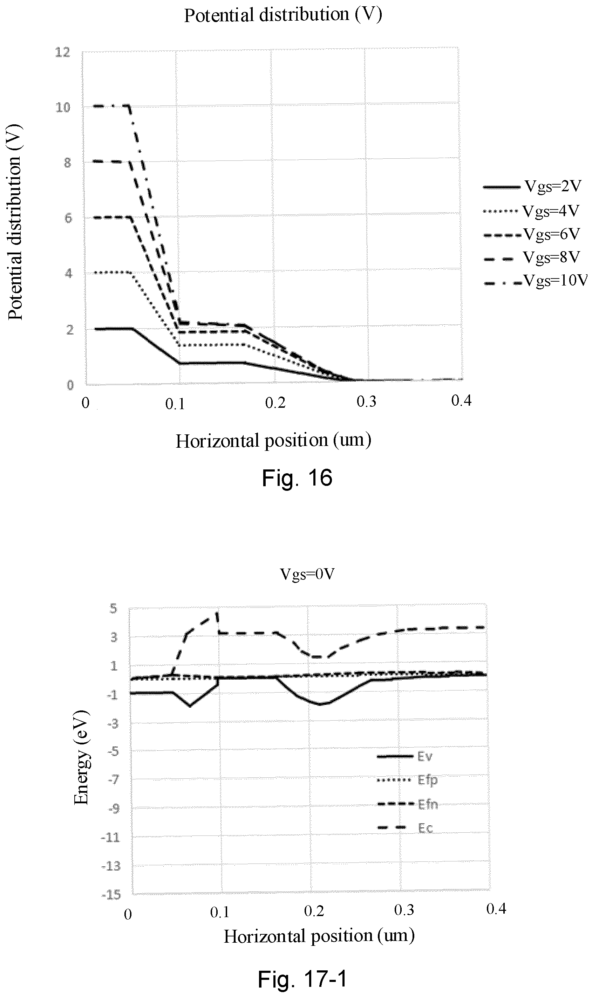

Fig. 16 is a potential distribution diagram of the vertical trench coupling capacitance gate-controlled junction field effect transistor according to the present disclosure.

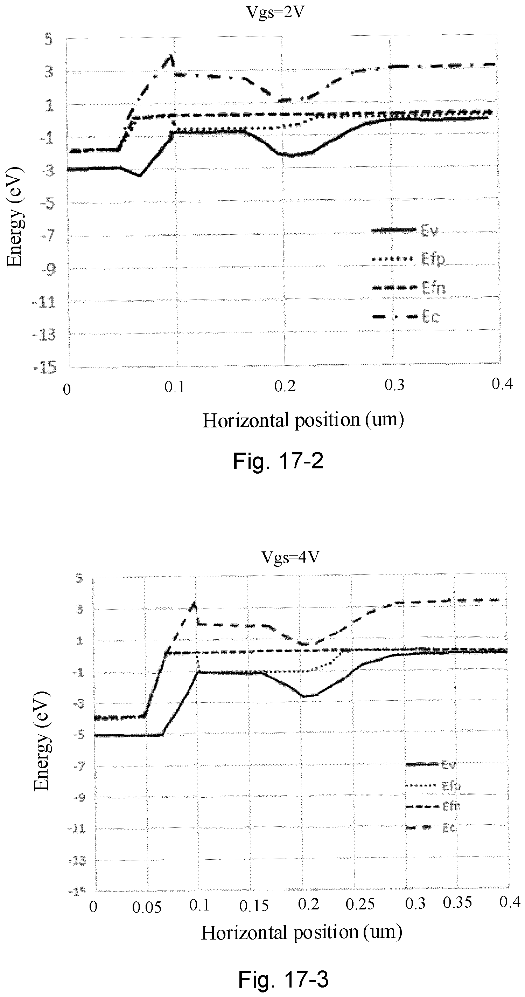

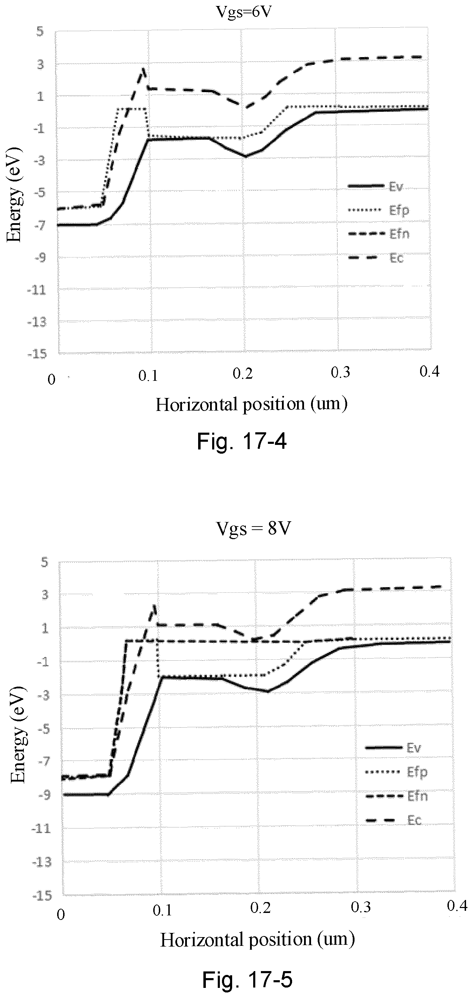

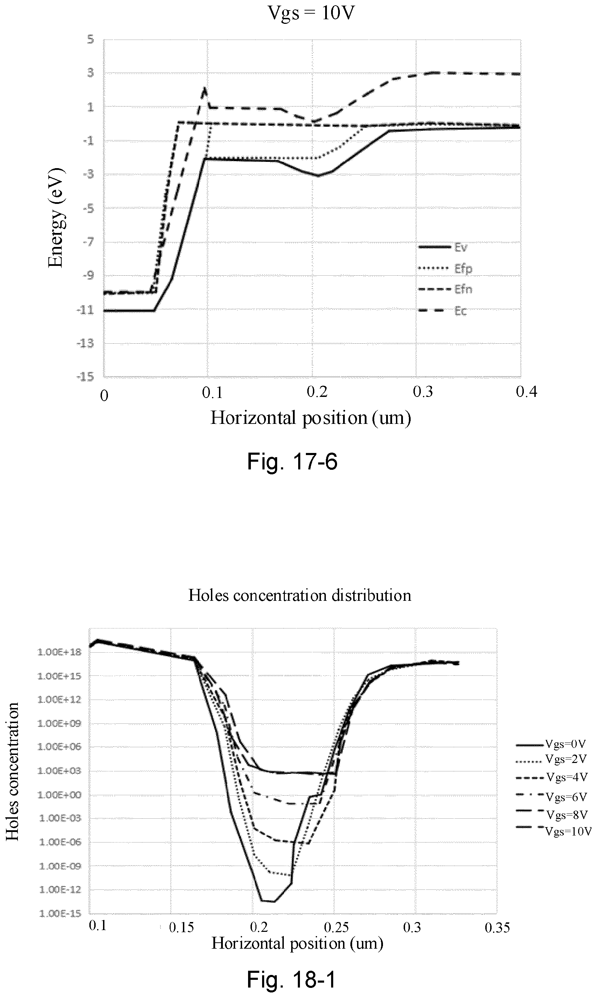

Figs. 17-1, 17-2, 17-3, 17-4, 17-5, and 17-6 are energy band distribution diagrams for different voltages applied to the coupling capacitance upper electrode of the vertical trench coupling capacitance gate-controlled junction field effect transistor according to the present disclosure.
Fig. 18-1 is a carrier concentration distribution diagram in each region of the vertical trench coupling capacitance gate-controlled junction field effect transistor according to the present disclosure when working, illustrating the hole concentration in the gate, the channel, and the second doping type ohmic contact region affected by the voltage applied to the coupling capacitance upper electrode.

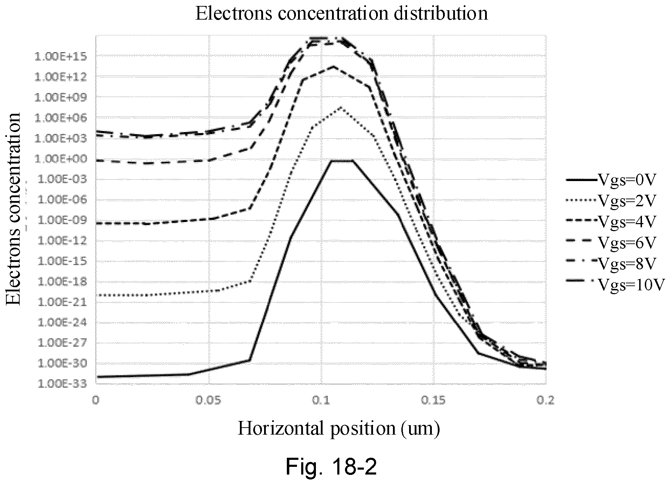

Fig. 18-2 is a carrier concentration distribution diagram in each region of the vertical trench coupling capacitance gate-controlled junction field effect transistor according to the present disclosure when working, illustrating the electron concentration in the gate, the channel, and the second doping type ohmic contact region affected by the voltage applied to the coupling capacitance upper electrode.

### REFERENCES IN THE DRAWINGS:

substrate 1, epitaxial layer 2, second doping type ohmic contact region 3;
source region 4, channel 5, gate 6; and
dielectric layer 7, coupling capacitance upper electrode 8, source electrode 9, drain electrode 10, metal silicide layer 11.

### DETAILED DESCRIPTION OF THE EMBODIMENTS

In order to make technical solutions and advantages of embodiments of the disclosure clearer, exemplary embodiments of the disclosure are described in further detail below in combination with accompanying drawings. Obviously, the described embodiments are only part of the embodiments of the disclosure, not an exhaustive list of all embodiments. It should be noted that the embodiments of the disclosure and features in the embodiments may be combined with each other without conflicts.

Traditional semiconductor devices are often manufactured with the first-generation semiconductor material silicon. In recent years, the third-generation wide band gap semiconductor material silicon carbide has material advantages, such as wide band gap, high breakdown voltage, and high thermal conductivity, and the semiconductor device based on the third-generation semiconductor material silicon carbide has shown significant performance advantages over the semiconductor device based on silicon. However, at present, the growth of the silicon carbide material is immature, the semiconductor device based on silicon carbide material has performance and reliability problems, such as the low surface mobility of the silicon carbide material due to more surface defects near the silicon carbide material surface, which seriously affects the improvement of the device performance. The silicon carbide device requires high-quality of gate oxide, and the conventional gate oxide quality makes it difficult to satisfy the reliability requirements. For the same type of power device of the conventional technology, the conducted channel is disposed on the surface of the silicon carbide material and the oxide. Due to the silicon carbide material characteristic, many charges and defects exist on the surface of the silicon carbide and the oxide, which affects the carrier mobility in the channel, and the carrier mobility of the channel is much lower than the body mobility of the silicon carbide material. The channel mobility of the silicon carbide MOSFET, i.e., the surface mobility, is in the range of 20 cm²/V·s to 40 cm²/V·s, and the body mobility of silicon carbide material is about 1000 cm²/V·s. The low channel mobility affects the current transfer characteristics and the conducting resistance of the device. The portion of the flow through the surface of the device is disposed below the gate oxide, the operating reliability of the gate electrode in the device can be affected by the center of the unstable traps and defects.

For the same type of power device of the conventional technology, the vertical epitaxial layer-JFET region-dielectric layer is the main voltage-bearing region under the high drain electrode voltage (the breakdown conditions) making the device off. According to the relationship D=ε·E among the electric displacement vector, the electric field intensity, and the dielectric constant, the electric displacement vector within the semiconductor material is Dₛₑₘ=εₛₑₘ·Eₛₑₘ, the electric displacement vector within the dielectric layer immediately adjacent to the semiconductor material is D_{die}=ε_{die}·E_{die}, the electric displacement vector is continuous in the surface of the semiconductor material and the dielectric layer, that is, Dₛₑₘ=D_{die}, so εₛₑₘ·Eₛₑₘ=ε_{die}·E_{die}. In a case where the dielectric is immediately adjacent to a different semiconductor material, such as the substrates are silicon material and silicon carbide materials, the dielectric constant ε of the two semiconductor materials are essentially the same (ε_{Si}=11.8, ε_{SiC}=9.8), however, the critical breakdown field strength of the third-generation wide band gap semiconductor material silicon carbide is much larger than the critical breakdown field strength of silicon carbide material (E_{Si}=0.23 MV/cm, E_{SiC}=2.2 MV/cm), and the electric field intensity within the dielectric layer of the silicon carbide is much larger than that of the silicon material according to εₛₑₘ·Eₛₑₘ=ε_{die}·E_{die}. Therefore, the dielectric layer (oxide layer or high-k dielectric) under the gate has a high electric field intensity in a case where the silicon-based device is in the breakdown state, the typical value is about 2×10⁶ V/cm, and the electric field intensity is on the order of megavolts per centimeter. The high electric field intensity within the dielectric layer affects the operating reliability of the gate electrode of the silicon-based device.

In conclusion, the conventional silicon carbide-based junction field effect transistor in conventional technology not only has a technical problem in that the gate electrode cannot be applied to a higher voltage and has a low reliability limiting the application as a power switch, but also has a technical problem about poor performance caused by the conducting channel being closed to the material surface with low mobility, and also has a technical problem of poor device reliability caused by the poor quality of the gate dielectric layer.

The trench vertical double-diffused MOSFET (Trench VDMOS) device is in an improved structure based on the planar-type VDMOS, in which the gate electrode is formed by etching the trench to make the gate electrode deep inside to control the on-off of the channel and strengthen the ability of the gate to control the channel and realize the lower conducting resistance Rsp and lower conducting current Idsat.

A P-type channel Trench VDMOS device structure according to patent No. CN113363308A, as shown in Fig. 2. A polysilicon gate is in a trench-type structure deep inside the device, attracts changes near the channel in the n base region (n base) by the MOS capacitance effect of the gate oxide, controls whether the n base is inverted, and controls the on-off of the channel. During the working of the device, the inverse channel of the n base is controlled by the polysilicon gate close to the gate oxide (the closer to the polysilicon gate, the greater the influence of the gate), i.e., the junction between the trench and the gate oxide of the device. That is, a portion of the conducted channel is located inside the P-drift region, and another portion is along the surface of the trench near the gate oxide. The same low mobility problem caused by the planar-type VDMOS with the conducted channel located on the surface of the device, the problem for the Trench VDMOS of the charges, defects, and the surface scattering at the interface between the surface of the trench and the gate oxide layer is more serious by the trench etching, and the low carrier mobility on the surface of the trench of the semiconductor results in a low saturation current Idsat of the device and a high conducting resistance Rsp affecting the device performance and limiting the output power and switch speed of the device. The Trench VDMOS, as an ideal vertical trench coupling capacitance gate-controlled junction field effect transistor applied in switching applications and linear applications, is mainly applied in electronic switches, adapters, drive band energy, industrial control, etc.

### Embodiment 1

As shown in Fig. 3-1 and Fig. 3-4, the first implementation of a vertical trench coupling capacitance gate-controlled junction field effect transistor according to the present disclosure comprises: a substrate 1 of a first doping type, an epitaxial layer 2 of the first doping type, and a plurality of repeating units, where the epitaxial layer 2 is disposed on the substrate 1, the substrate 1 is served as a drain region; and each of the repeating units comprise:

two source regions 4 of the first doping type, formed inside the epitaxial layer 2 and spaced apart in the lateral direction;
a trench, formed downwardly from an upper surface of the epitaxial layer 2 and disposed between the two source regions 4 of the first doping type;
a gate 6 of the second doping type, formed an inner wall and a bottom of the trench; where the gate 6 is in a floating state;
a dielectric layer 7, at least formed on the inner bottom of the gate 6; and
a coupling capacitance upper electrode 8, formed on the dielectric layer 7.

A JFET region formed by the gate 6 of the second doping type, the epitaxial layer 2 of the first doping type, and another gate 6 of the second doping type in the adjacent repeating unit (i.e., a JEFT region formed by the two gates 6 of the second doping type in the adjacent two repeating units and regions of the epitaxial layer 2 between the adjacent two gates 6 of the second doping type). The gates 6 in the JFET region are indirectly controlled by the coupling capacitance upper electrode 8 spaced with the dielectric layer 7.

For the vertical trench coupling capacitance gate-controlled junction field effect transistor of the embodiments of the present disclosure, the gate 6 of the JFET region is indirectly controlled by the coupling capacitance upper electrode 8 spaced with the dielectric layer 7, the coupling capacitance upper electrode voltage applied to the coupling capacitance upper electrode 8 is coupled to the gate 6 by coupling. Since the gate 6 is in a floating state which is not directly connected to the gate electrode, the electric potential of the coupling capacitance upper electrode 8 can be increased to more than 3V without causing the coupling capacitance upper electrode 8, the substrate 1 and the lower portion of the epitaxial layer located under the gate 6 to conduct. Compared with the JFET device according to patent No. CN1238904C, the transistor of the embodiment of the present disclosure cannot be conducted even if a high voltage (more than 3V, e.g., 4V, 5V) is applied to the coupling capacitance upper electrode 8, and which does not affect the current characteristic from the drain electrode to the source electrode. The gate 6 is indirectly controlled by the coupling capacitance upper electrode 8 spaced with the dielectric layer 7 so that no current flows through the gate 6 and the reliability is high.

Specifically, the dielectric layer 7 can prevent the coupling capacitance upper electrode from turning on the injection to affect the reliability of the device and improve the operating voltage.
the vertical trench coupling capacitance gate-controlled junction field effect transistor of the embodiments of the present disclosure is neither a conventional JFET device nor a conventional Trench VDMOS device, but a vertical trench coupling capacitance gate-controlled junction field effect transistor with a novel structure.

In the JFET device according to patent No. CN1238904C, the coupling capacitance upper electrode and the channel formed a PN junction structure, and a voltage higher than 3V cannot be applied to the coupling capacitance upper electrode. For SiC material served as a substrate, a voltage of 3V or more is applied to thecoupling capacitance upper electrode, the coupling capacitance upper electrode and the channel are conducted or the coupling capacitance upper electrode and the source electrode are conducted, and the conducting current strongly affects the current characteristic from the drain electrode to the source electrode. The coupling capacitance upper electrode cannot be applied to a higher voltage limits the application as a power switch.

The essential difference between the vertical trench coupling capacitance gate-controlled junction field effect transistor of the embodiments of the present disclosure and the conventional JFET device is as follows:
the vertical trench coupling capacitance gate-controlled junction field effect transistor of the embodiments of the present disclosure indirectly controls the gate by the capacitive coupling principle, avoiding the injection current from the coupling capacitance upper electrode into the channel, and a higher voltage can be applied to the coupling capacitance upper electrode to control the channel. The vertical trench coupling capacitance gate-controlled junction field effect transistor can be applied to more application scenarios.

The main difference between the vertical trench coupling capacitance gate-controlled junction field effect transistor of the embodiment of the present disclosure and the JFET device is as follows:
the vertical trench coupling capacitance gate-controlled junction field effect transistor of the embodiments of the present disclosure controls the electric potential of the floating gate 6 spaced with the dielectric layer 7 by the coupling capacitance upper electrode 8 vie the capacitive coupling principle, and indirectly controls on and off of the channel.

The top gate of the conventional JFET device is directly connected to the electrode, in a case where a high voltage is applied, the PN junction formed between the top gate and the channel is conducted, and currents flow from the top gate into the channel causing negative effects. The vertical trench coupling capacitance gate-controlled junction field effect transistor of the embodiments of the present disclosure has a insulative dielectric layer structure, which can avoid the problem.

In the embodiment, as shown in Fig. 3-1, the vertical trench coupling capacitance gate-controlled junction field effect transistor further comprises:
a drain electrode 10, disposed on a lower surface of the substrate 1; and
two source electrode 9, formed on the two source regions 4 respectively.

The internal conducting paths within the substrate 1 and the epitaxial layer 2 from a drain electrode 10 to two source electrodes 9 are formed by the substrate 1 of the first doping type, the epitaxial layer 2 of the first doping type, and the two source regions 4 of the first doping type.

In the vertical trench coupling capacitance gate-controlled junction field effect transistor of the embodiment of the present disclosure, the epitaxial layer of the first doping type realizes the main structure of the semiconductor device (the gate 6 and the source region 4 are part of the semiconductor device). The source regions 4 are disposed in the upper portion of the epitaxial layer 2, thus the source region 4 is disposed inside the epitaxial layer from top to bottom. It is ensured that the substrate 1, the epitaxial layer 2, and the two source regions are all of the first doping type, and internal conducting paths in the substrate 1 and the epitaxial layer 2 from the drain electrode 10 to the source electrode 9 ( represented by the dotted lines in Fig. 3-1) are formed by the substrate 1 of the first doping type, the epitaxial layer 2 of the first doping type, and the two source regions 4 of the doping type, and the internal conducting paths are all away from the surface of the trench. That is, the internal conducting paths are all away from the surface of the semiconductor material and the surface of the trench, and as a body conduction avoiding the problem of low surface mobility. In the vertical trench coupling capacitance gate-controlled junction field effect transistor of the embodiments of the present disclosure, the internal conducting paths are disposed inside the vertical trench coupling capacitance gate-controlled junction field effect transistor and are away from the surface of the trench and the surface of the semiconductor, so the carriers are kept in a state of high mobility and drift velocity. The saturation current Idsat of the vertical trench coupling capacitance gate-controlled junction field effect transistor is relatively large, the conducting resistance Rsp of the vertical trench coupling capacitance gate-controlled junction field effect transistor is relatively small, and the performance of the vertical trench coupling capacitance gate-controlled junction field effect transistor is relatively good.

In the Trench VDMOS according to patent No. CN116598356A, one part of the conducting channel disposed inside the device in the vertical direction, and the other part of the conducting channel is along the surface of the trench. That is, the conducting channel is partially on the surface of the trench. The reason the conducting channel is partially on the surface of the trench is that: the PN junction is formed by the P-type drift region (P-drift) and the N-type base region (N-base), and in a case where no voltage is applied the PN junction, the PN junction is off. In a case where a voltage is applied to the polysilicon gate, the part of the PN junction closest to the polysilicon gate, that is, the surface of the trench is most likely to inversely form a trench to conduct, thus the conducting channel disposed on the surface of the trench, that is, along the surface of the trench. The problem of the charges, defects, and the surface scattering at the interface between the surface of the trench and the gate oxide layer is more serious by trench etching, and the low carrier mobility on the surface of the trench of the semiconductor results in a low saturation current Idsat of the device and a high conducting resistance Rsp, affecting the device performance and limiting the output power and switch speed of the device.

In the vertical trench coupling capacitance gate-controlled junction field effect transistor of the embodiments of the present disclosure, the substrate 1, the epitaxial layer 2, and the two source regions 4 are all the first doping type, not forming a PN junction and conducting by themselves, therefore the internal conducting paths within the substrate 1 and the epitaxial layer 2 from the drain electrode 10 and the source electrode 9. The internal conducting paths are away from the surface of the semiconductor material, and the internal conducting paths are away from the surface of the trench, that is, the internal conducting paths are all away from the surface of the semiconductor material and the surface of the trench, as body conduction avoiding the problem of low surface mobility.

In the embodiment, as shown in Fig 3-1, the trench is in a U-type shape, correspondingly, the dielectric layer 7 covers the coupling capacitance upper electrode space surrounded by the inner wall of the gate 6, and the dielectric layer 7 covers the top of the gate.

The coupling capacitance upper electrode 8 is formed in the coupling capacitance upper electrode space.

The trench gate 6 formed in a U-type shape by etching the U-type trench, making the gate 6 penetrate the device inside to control the on-off of the JFET region, strengthening the ability of the gate 6 to control the JFET region. Compared with the planar-type VDMOS device, lower conducting resistance Rsp and lower conducting current Idsat can be realized.

In the embodiment, the substrate 1 is selected from at least one of silicon carbide substrate, silicon substrate, diamond substrate, or potassium oxide substrate.
the dielectric layer 7 is made of high dielectric constant material; or
the coupling capacitance upper electrode 8 is selected from at least one of polycrystalline silicon electrode or metal electrode.

The dielectric layer with the diamond substrate in the conventional MOSFET has a problem: the dielectric layer formed on the diamond substrate by depositing, such as the oxide layer, is of poor quality, resulting in poor performance. The problem can be solved by the structure of the diamond vertical trench capacitive coupling gate-controlled junction field effect transistor device with the conducting channel disposed inside the device. Metal-oxide-semiconductor field effect transistor (MOSFET) is a conventional semiconductor device.

Potassium oxide, as a fourth-generation semiconductor material, can be made into electron components and electron devices, especially novel controllable semiconductor devices.

Specifically, the material of the dielectric layer can be selected from silicon dioxide or high-k dielectric, and it is more conducive with high-k dielectric to controll the P+ type top gate by the coupling capacitance upper electrode and improve the performance of the device.

Specifically, the gate 6 can be selected from P+ type and N+ type heavily doped polycrystalline silicon, reducing the metal contact resistance and the parasitic resistance of the coupling capacitance upper electrode, and improving the device performance.

The high-k dielectric is a material with a high dielectric constant (high relative dielectric constant).

Specifically, the substrate 1 of the first doping type is heavy-doped with a high doping concentration and serves as the drain region of the vertical trench coupling capacitance gate-controlled junction field effect transistor.

In the embodiment, the vertical trench coupling capacitance gate-controlled junction field effect transistor further comprises:
a metal silicide layer (not shown in Fig. 3-1), formed between the gate 6 and the dielectric layer 7.

Adding the metal silicide layer (referred to as silicide layer) under the dielectric layer of the coupling capacitance upper electrode, that is, the metal silicide layer can be between the dielectric layer 7 and the gate 6. Thus, the metal silicide layer under the dielectric layer 7 is a metal layer, and the electric field is uniformly distributed inside the metal layer, optimizing the electric field of the gate 6 and improving the reliability of the device.

In the embodiment, the doping concentration of the gate 6 is largerthan or equal to 1×10¹⁶cm⁻³.

The doping concentration of the gate 6 is larger than or equal to 1×10¹⁶cm⁻³ ensures in a case where a voltage is applied to the gate electrode, the top gate is not in a depleted state and the gate has no strong electric field.

In the embodiment, a doping concentration of the channel 5 is larger than a doping concentration of the substrate 1 and the epitaxial layer 2.

The doping concentration of the channel is larger than the doping concentration of the base, facilitating to reduction of the conducting resistance of the device and improving the device's performance.

The vertical trench coupling capacitance gate-controlled junction field effect transistor according to Embodiment 1 can be realized as a normally-off device or a normally-on device.

The method of realizing the vertical trench coupling capacitance gate-controlled junction field effect transistor according to Embodiment 1 as a normally-off device is as follows:
by controlling the doping of the two gates 6 of the second doping type in the two adjacent repeating units, in a case where a voltage applied to the coupling capacitance upper electrode 8 is 0V, a region between the two gates 6 of the second doping type in the two adjacent repeating units inside the epitaxial layer 2 is in a depleted state and the vertical trench coupling capacitance gate-controlled junction field effect transistor is a normally-off device.

The vertical trench coupling capacitance gate-controlled junction field effect transistor is realized as a normally-off device by adjusting the doping position and the doping concentration of the two gates 6 of the second doping type in the two adjacent repeating units.

The method of realizing the vertical trench coupling capacitance gate-controlled junction field effect transistor as a normally-off device is as follows:

In a case where the first doping type is N-type doping and the second doping type is P-type doping:
in a case where no voltage is applied to the vertical trench capacitive coupling gate-controlled junction field effect transistor, the vertical trench coupling capacitance gate-controlled junction field effect transistor is turned off; and
in a case where a positive voltage is applied to the vertical trench coupling capacitance gate-controlled junction field effect transistor, the vertical trench coupling capacitance gate-controlled junction field effect transistor is conducted.

In a case where the first doping type is P-type doping and the second doping type is N-type doping:
in a case where no voltage is applied to the vertical trench capacitive coupling gate-controlled junction field effect transistor, the vertical trench coupling capacitance gate-controlled junction field effect transistor is turned off; and
in a case where a negetive voltage is applied to the vertical trench coupling capacitance gate-controlled junction field effect transistor, the vertical trench coupling capacitance gate-controlled junction field effect transistor is conducted.

The method of realizing the vertical trench coupling capacitance gate-controlled junction field effect transistor according to Embodiment 1 as a normally-on device is as follows:
by controlling the doping position or doping concentration of the two gates 6 of the second doping type in the two adjacent repeating units, in a case where a voltage applied to the coupling capacitance upper electrode 8 is 0V, a region between the two gates 6 of the second doping type in the two adjacent repeating units inside the epitaxial layer 2 is in a conducted state and the vertical trench coupling capacitance gate-controlled junction field effect transistor is a normally-on device.

The vertical trench coupling capacitance gate-controlled junction field effect transistor is realized as a normally-on device by adjusting the doping position and the doping concentration of the two gates 6 of the second doping type in the two adjacent repeating units.

The method of realizing the vertical trench coupling capacitance gate-controlled junction field effect transistor as a normally-on device is as follows:
in a case where the first doping type is N-type doping and the second doping type is P-type doping:
in a case where no voltage is applied to the vertical trench coupling capacitance gate-controlled junction field effect transistor, the vertical trench coupling capacitance gate-controlled junction field effect transistor is conducted.
in a case where a negative voltage is applied to the vertical trench coupling capacitance gate-controlled junction field effect transistor, the vertical trench coupling capacitance gate-controlled junction field effect transistor is turned off.

In a case where the first doping type is P-type doping and the second doping type is N-type doping:
in a case where no voltage is applied to the vertical trench coupling capacitance gate-controlled junction field effect transistor, the vertical trench coupling capacitance gate-controlled junction field effect transistor is conducted; or
in a case where a positive voltage is applied to the vertical trench coupling capacitance gate-controlled junction field effect transistor, the vertical trench coupling capacitance gate-controlled junction field effect transistor is turned off.

That is, the region of the epitaxial layer between the two gates 6 of the second doping type in the two adjacent repeating units is a portion between the two gates 6 of the second doping type in the two adjacent repeating units of the epitaxial layer 2.

### Embodiment 2

The second implementation (Embodiment 2) of the vertical trench coupling capacitance gate-controlled junction field effect transistor according to the present disclosure, compared with the first implementation (i.e., Embodiment 1) of a vertical trench coupling capacitance gate-controlled junction field effect transistor, as shown in Fig. 3-2, the difference in structure is that the second implementation (i.e., Embodiment 2) of a vertical trench coupling capacitance gate-controlled junction field effect transistor according to the present disclosure further comprises:
two channels 5 of the first doping type, disposed below the two source regions 4 respectively.

A JFET region is formed by the gate 6 of the second doping type, the channels 5 of the first doping type, another gate 6 of the second doping type in the adjacent repeating unit, and the gates 6 in the JFET region are indirectly controlled by the coupling capacitance upper electrode 8 spaced with the dielectric layer 7.

Correspondingly, as shown in Fig. 3-2, where internal conducting paths within the substrate 1 and the epitaxial layer 2 from the drain electrode to two source electrodes are formed by the substrate 1 of the first doping type, the epitaxial layer 2 of the first doping type, the two channels 5 of the first doping type, and the two source electrodes 4 of the first doping type.

Specifically, the channel 5 can be formed by the ion implantation process or other processes by the original base. and making a doping concentration of the channel 5 larger than a doping concentration of epitaxial layer 2.

Specifically, the doping concentration of the channel 5 of the first doping type higher than the doping concentration of the epitaxial layer 2, making the resistance of the channel 5 is relatively small, and further the conducting resistance Rsp of the vertical trench coupling capacitance gate-controlled junction field effect transistor is relatively small, and the performance of the vertical trench coupling capacitance gate-controlled junction field effect transistor is relatively good.

Correspondingly, the vertical trench coupling capacitance gate-controlled junction field effect transistor according to Embodiment 2 can be realized as a normally-off device and a normally-on device.

The method of realizing the vertical trench coupling capacitance gate-controlled junction field effect transistor according to Embodiment 2 as a normally-off device is as follows:
by controlling the doping position or doping concentration of the two gates 6 of the second doping type in the two adjacent repeating units, in a case where a voltage applied to the coupling capacitance upper electrode 8 is 0V, the channel 5 between the two gates 6 of the second doping type in the two adjacent repeating units are in a depleted state and the vertical trench coupling capacitance gate-controlled junction field effect transistor is a normally-off device.

The vertical trench coupling capacitance gate-controlled junction field effect transistor is realized as a normally-off device by adjusting the doping position and the doping concentration of the two gates 6 of the second doping type in the two adjacent repeating units.

The method of realizing the vertical trench coupling capacitance gate-controlled junction field effect transistor according to Embodiment 2 as a normally-on device is as follows:
by controlling the doping position or doping concentration of the two gates 6 of the second doping type in the two adjacent repeating units, in a case where a voltage applied to the coupling capacitance upper electrode 8 is 0V, the channels 5 between the two gates 6 of the second doping type in the two adjacent repeating units are in a conducted state and the vertical trench coupling capacitance gate-controlled junction field effect transistor is a normally-on device.

The vertical trench coupling capacitance gate-controlled junction field effect transistor is realized as a normally-on device by adjusting the doping position and the doping concentration of the two gates 6 of the second doping type in the two adjacent repeating units.

This is, the channel 5 is the region between the two gates 6 of the second doping type in the two adjacent repeating units.

The JFET device according to patent No. CN1238904C is a normally-on device, that is, in a case where no voltage is applied to the gate electrode, the device is conducted, and a negative voltage must be applied to the gate to turn off the device, which limits the application as a power switch.

### Embodiment3

The third implementation (Embodiment 3) of the vertical trench coupling capacitance gate-controlled junction field effect transistor according to the present disclosure, compared with the first implementation (i.e., Embodiment 1) of a vertical trench coupling capacitance gate-controlled junction field effect transistor, as shown in Fig. 3-3, the difference in structure is that the third implementation of a vertical trench coupling capacitance gate-controlled junction field effect transistor according to the present disclosure further comprises:
two second doping type ohmic contact regions 3, disposed outside the two source regions 4 respectively.

A JFET region formed by the gate 6 of the second doping type, a region of the epitaxial layer 2 between the gate 6 of the second doping type and the second doping type ohmic contact region 3, and the second doping type ohmic contact region 3. The gate 6 of the JFET region is indirectly controlled by the coupling capacitance upper electrode 8 spaced with the dielectric layer 7.

The function of the second doping type ohmic contact region 3, is to adjust the electric field to improve the breakdown voltage (BV) of the device and improve the reliability of the device.

Correspondingly, as shown in Fig. 3-3, internal conducting paths within the substrate 1 and the epitaxial layer 2 from a drain electrode 10 to two source electrodes are formed by the substrate 1 of the first doping type, the epitaxial layer 2 of the first doping type, the two source electrodes 4 of the first doping type.

The vertical trench coupling capacitance gate-controlled junction field effect transistor according to Embodiment 3 can be realized as a normally-off device and a normally-on device.

The method of realizing the vertical trench coupling capacitance gate-controlled junction field effect transistor according to Embodiment 3 as a normally-off device is as follows:
by controlling a doping of the gate 6 of the second doping type and the second doping type ohmic contact region 3, in a case where a voltage applied to the coupling capacitance upper electrode 8 is 0V, a region between the gate 6 of the second doping type and the second doping type ohmic contact region 3 is in a depleted state and the vertical trench coupling capacitance gate-controlled junction field effect transistor is a normally-off device.

Where the vertical trench coupling capacitance gate-controlled junction field effect transistor is realized as a normally-off device by adjusting the doping position and the doping concentration of the two gates 6 of the second doping type in the two adjacent repeating units and the second doping type ohmic contact region 3.

The method of realizing the vertical trench coupling capacitance gate-controlled junction field effect transistor according to Embodiment 3 as a normally-on device is as follows:

by controlling a doping position or doping concentration of the gate 6 of the second doping type and the second doping type ohmic contact region 3, in a case where a voltage applied to the coupling capacitance upper electrode 8 is 0V, a region between the gate 6 of the second doping type and the second doping type ohmic contact region 3 is in a conducted state and the vertical trench coupling capacitance gate-controlled junction field effect transistor is a normally-on device.

Where the vertical trench coupling capacitance gate-controlled junction field effect transistor is realized as a normally-on device by adjusting the doping position and the doping concentration of the two gates 6 of the second doping type in the two adjacent repeating units and the second doping type ohmic contact region 3.

That is, the region between the gate 6 of the second doping type and the second doping type ohmic contact region 3 is a portion of the epitaxial layer 2 between the gate 6 of the second doping type and the second doping type ohmic contact region 3.

Specifically, the second doping type ohmic contact region 3 can be formed by the ion implantation process or other processes by the original base.

### Embodiment 4

The fourth implementation (Embodiment 4) of the vertical trench coupling capacitance gate-controlled junction field effect transistor according to the present disclosure, compared with the first implementation (i.e., Embodiment 1) of a vertical trench coupling capacitance gate-controlled junction field effect transistor, as shown in Fig. 3-4, the difference in structure is that the fourth implementation (i.e., Embodiment 4) of a vertical trench coupling capacitance gate-controlled junction field effect transistor according to the present disclosure further comprises:
two channels 5 of the first doping type, disposed below the two source regions 4 respectively; and
two second doping type ohmic contact regions 3, disposed outside the two source regions 4 respectively.

A JFET region is formed by the gate 6 of the second doping type, the channels 5 of the first doping type, and second doping type ohmic contact regions 3, and the gate 6 in the JFET region is indirectly controlled by the coupling capacitance upper electrode 8 spaced with the dielectric layer 7.

The gate 6, the channel 5, the source region 4, and the second doping type ohmic contact region 3 are formed inside the epitaxial layer 2.

Fig. 3-4 shows two adjacent repeating units, Correspondingly, internal conducting paths within the substrate 1 and the epitaxial layer 2 from the drain electrode 10 to two source electrodes 9 are formed by the substrate 1 of the first doping type, the epitaxial layer 2 of the first doping type, the two channels 5 of the first doping type, and the two source electrodes 4 of the first doping type.

Specifically, the substrate 1 of the first doping type, the epitaxial layer 2 of the first doping type, the two channels 5 of the first doping type, and the two source regions 4 of the first doping type are connected sequentially. The current transported from the drain electrode 10 flows through the substrate 1 of the first doping type and the epitaxial layer 2 of the first doping type to the channels 5 of the first doping type on the left side and right side, to the source regions 4 on the left side and right side, and finally collected by the two source regions 9 on the left side and right side.

Specifically, the channels 5 can be formed by the ion implantation process or other processes by the original base, making a doping concentration of the channels 5 larger than a doping concentration of epitaxial layer 2.

Specifically, the doping concentration of the channel 5 of the first doping type higher than the doping concentration of the epitaxial layer 2, making the resistance of the channel 5 is relatively small, and further the conducting resistance Rsp of the vertical trench coupling capacitance gate-controlled junction field effect transistor is relatively small, and the performance of the vertical trench coupling capacitance gate-controlled junction field effect transistor is relatively good.

The present disclosure provides a vertical trench coupling capacitance gate-controlled junction field effect transistor. The threshold voltage is 3.03V, the breakdown voltage is 1507V, and the conducting resistance is 0.12Ω·mm² of the device in the embodiment. The conducting channels of the vertical trench coupling capacitance gate-controlled junction field affect the transistor of the present disclosure all disposed inside the device and are less affected by the charges on the interface and the low mobility of the interface. The conducting resistance is improved by 50% compared with the conventional silicon carbide VDMOS. The dielectric layer is protected by the gate, the junction field effect region protecting the coupling capacitance upper electrode can be reduced, and the conducting resistance can be further reduced. Due to the capacitive coupling effect of the channel, the current of the present disclosure is saturated at a high gate voltage, improving the short-circuit resistance capability of the device. The coupling capacitance upper electrode of the vertical trench coupling capacitance gate-controlled junction field effect transistor of the present disclosure is a coupling capacitance gate, utilizing the principle of capacitive coupling to operate and control the device working. The electrode work function of the capacitance is low and the coupling capacitance dielectric can be flexibly selected. In a case where the device is broken down, the typical electric field intensity in the dielectric layer is about 2×10⁵V/cm, lower than the typical electric field intensity of the conventional silicon carbide device by about an order of magnitude. The quality of the capacitive coupling dielectric is low and has obvious advantages in high reliability, robustness, and manufacturability.

The following is an example of a case where the first doping type is N-type, and the second doping type is P-type:
a JFET region formed by a P+ type ohmic contact region 3, an N-type channel 5, and a P+ type gate 6, a PN junction formed between the P+ type ohmic contact region 3 and the N-type channels 5, and a PN junction formed between the N-type channel 5 and the P+ type gate 6. By controlling the voltage of the coupling capacitance upper electrode 8, the channel 5 is depleted and pinched off, so as to realize the controlling of the conducting paths, and finally realize the controlling of the on-off of the vertical trench coupling capacitance gate-controlled junction field effect transistor.

The vertical trench coupling capacitance gate-controlled junction field effect transistor according to Embodiment 4 can be realized as a normally-off device and a normally-on device.

The method of realizing the vertical trench coupling capacitance gate-controlled junction field effect transistor according to Embodiment 4 as a normally-off device is as follows:
by controlling a doping position or doping concentration of the gate 6 of the second doping type and the second doping type ohmic contact region 3, in a case where a voltage applied to the coupling capacitance upper electrode 8 is 0V, the channel 5 between the gate 6 of the second doping type and the second doping type ohmic contact region 3 is in a depleted state and the vertical trench coupling capacitance gate-controlled junction field effect transistor is a normally-off device.

Where the vertical trench coupling capacitance gate-controlled junction field effect transistor is realized as a normally-off device by adjusting the doping position and the doping concentration of the two gates 6 of the second doping type in the two adjacent repeating units and the second doping type ohmic contact region 3.

The method of realizing the vertical trench coupling capacitance gate-controlled junction field effect transistor according to Embodiment 4 as a normally-on device is as follows:
by controlling a doping position or doping concentration of the gate 6 of the second doping type and the second doping type ohmic contact region 3, in a case where a voltage applied to the coupling capacitance upper electrode 8 is 0V, the channel 5 between the gate 6 of the second doping type and the second doping type ohmic contact region 3 is in a conducted state and the vertical trench coupling capacitance gate-controlled junction field effect transistor is a normally-on device.

Where the vertical trench coupling capacitance gate-controlled junction field effect transistor is realized as a normally-on device by adjusting the doping position and the doping concentration of the two gates 6 of the second doping type in the two adjacent repeating units and the second doping type ohmic contact region 3.

That is, the region between the gate 6 of the second doping type and the second doping type ohmic contact region 3 is the channel 5.

The following is an example of a case where the first doping type is N-type, and the second doping type is P-type:

The JFET region of the vertical trench coupling capacitance gate-controlled junction field effect transistor of the embodiments of the present disclosure is connected to the depletion region of the self-build electric field formed by the PN junction through the depletion region of the self-built electric field formed by the coupling capacitance upper electrode 8 and the N-type channel 5 to realize the self-depletion and the pinch-off of the N-type channel 5, and further to realize the on-off of the device. This is, in a case where no voltage is applied to the coupling capacitance upper electrode 8, the path between the drain electrode 10 and the source electrode 9 is turned off; and in a case where a voltage is applied to the coupling capacitance upper electrode 8, and the path between the drain electrode 10 and the source electrode 9 are conducted.

The following is an example of a case where the first doping type is N-type and the second doping type is P-type, a method manufacturing the vertical trench coupling capacitance gate-controlled junction field effect transistor of the present disclosure is described, and comprises the following steps:

As shown in Fig. 4, growing an N- type epitaxial layer 2 on the low-resistance SiC N+ type substrate 1, and the N+ type epitaxial layer 1 will be subsequently formed into an ohmic contact with metal in the backside of the drain electrode 10, and the N-type of the epitaxial layer 2 will be formed into the main structure of the device by the processes such as ion implantation, thermal annealing, etching, and deposition.

As shown in Fig. 5, based on the structure in Fig. 4, taking one single meta cell (repeating unit) of the device as an example, making the photoresist as a mask material by photolithography plate, forming a P+ type ohmic contact region 3, an N+ type source region 4, and an N-type channel 5 on the N- type epitaxial layer 2 by ion implantation. The device is in a middle-symmetric structure for a single meta cell, and the actual device consists of multiple identical arrangements of the meta cell.

As shown in Fig. 6, based on the structure in Fig. 5, etching SiC material to form a trench at the middle position of a single meta cell, that is, the middle part of the left and the right source electrode by the plasma etching process.

As shown in Fig. 7, based on the structure in Fig. 6, the SiC material into the trench inside and near the curved surface of the trench to form a P+ type gate 6 by the ion implantation process. In a case where the trench is relatively deep, make the side wall of the trench in a P-type in the vertical direction by the angled ion implantation. The P+ type gate 6 is not connected to the external metal electrode and is a physically floating region. The electric potential is coupled to the P+ type gate 6 by the voltage applied to the coupling capacitance upper electrode 8 and the capacitive coupling principle of the dielectric layer 7, further controlling the on-off of the N-type 5 by the JEFT effect. After the P+ type gate 6 is implanted, the overall implantation of the active region of the vertical trench coupling capacitance gate-controlled junction field effect transistor is completed, and each ion implantations are activated and diffused to form each region.

As shown in Fig.8, based on the structure in Fig. 7, the dielectric layer 7 on the surface of the trench and the surface of the wafer by chemical vapor deposition, and grinding to planarize the surface by chemical mechanical polishing. The material of the dielectric layer can be selected from oxide layer or other high-k dielectrics, and it is more conducive with high-k dielectric to control the P+ type gate 6 by the coupling capacitance upper electrode and improve the performance of the device. The high-k dielectric is a material with a high dielectric constant (high relative dielectric constant).

As shown in Fig. 9, based on the structure in Fig. 8, defining the region to be etched of the coupling capacitance upper electrode and the source region by the photoresist or the hard mask formed by a photolithography process, and etching the gate dielectric to form the trench coupling capacitance upper electrode and the source electrode to deposit metal by ion etching.

As shown in Fig. 10, based on the structure in Fig. 9, depositing metal to form the coupling capacitance upper electrode 8 in the trench region and forming the source electrode 9 in the junction region of the P+ type ohmic contact region 3 and the N+ type source region 4. Where the coupling capacitance upper electrode 8 can be formed into the polycrystalline silicon gate by depositing polycrystalline silicon, with the advantage that the coupling capacitance upper electrode 8 control capability can be adjusted by depositing.

As shown in Fig. 11, based on the structure in Fig. 10, after the front-side processes of the device are completed, grinding to be thin and metabolizing the back-side of the wafer, making the back-side drain electrode 10, and forming the complete device structure.

The operating principle of the vertical trench coupling capacitance gate-controlled junction field effect transistor of the present disclosure is described in detail as follows:

In the vertical trench coupling capacitance gate-controlled junction field effect transistor of the present disclosure, by the SiC wide band gap semiconductor characteristic, the band gap of the SiC is 3.4eV, so the Fermi level difference between the P-type SiC and the N-type SiC due to doping can be more than 3eV, thus the SiC PN junction can generate a built-in voltage of more than 3V, providing a device physics basis for the large modulation of the channel current of the junction field effect transistor. The channel current provided by the device physics is essentially different from the channel current provided by the channel doping, and the characteristic unique of the wide band gap semiconductor device physics was discovered for the first time in the present disclosure and will be explained in detail by energy band distribution diagrams later.

Three common methods of modulating the channel are provided in the relative art, the first method is a conventional Si MOSFET utilizing a reverse layer combined with high-quality silicon dioxide grown with a better adapted thermal oxygen to the silicon material and can be produced and applied on a large scaler.

The second method is the heterojunction FET, represented by GaAs/AIGaAs and GaN/AIGaN, and referred to as the HFET. The structure of the device is difficult to be enhanced-mode, and is solved by embedding the gate structure and fluorine ion implantation.

The third method is based on the JFET principle, silicon-based JFET device can only be formed into a normally-on device because the band gap of Si material is only 1.1eV. The conventional SiC-based device is also a normally-on device, and can not be applied as a power electronic switching device directly.

By the SiC material wide band gap characteristic, the vertical trench coupling capacitance gate-controlled junction field effect transistor of the present disclosure forms a high self-built voltage by the SiC wide band gap and realizes the function of the normally-off device. But the threshold voltage is less than 1V, the gate operating voltage is less than 3V, and the voltages still do not satisfy the requirements of the power electronic device. On this basis, the present disclosure provides the structure of the coupling capacitance gate, making the threshold voltage reach more than 3V, the operating voltage can reach more than 15V, and which fully matches the requirements of the conventional power electronic device.

The vertical trench coupling capacitance gate-controlled junction field effect transistor of the present disclosure is in a vertical device structure, as shown in Fig. 3-4, the drain electrode 10 is disposed below the substrate 1 at the bottom of the device, and the coupling capacitance upper electrode 8 and the source electrode 9 are disposed at the top of the device. The coupling capacitance upper electrode is in a trench structure. The dielectric layer 7 is disposed outside the coupling capacitance upper electrode 8, and the gate 6 is disposed outside the dielectric layer 7. The coupling capacitance upper electrode structure of the vertical trench coupling capacitance gate-controlled junction field effect transistor is formed as a whole by the coupling capacitance upper electrode 8, the dielectric layer 7, and the gate 6. The source region 4 and the channel 5 are immediately adjacent to the gate 6, the source region 4 and the channel 5 together with the epitaxial layer 2 and the substrate 1are formed the conducting path of the vertical trench device structure, and the second doping type ohmic contact region 3 is disposed on the other side of the source region 4 and the channel 5, the second doping type ohmic contact region together with the source region 4 connected to the source electrode 9. The JFET region is formed by the second doping type ohmic contact region 3, channel 5, and the gate 6.

The equivalent circuit diagram of the vertical trench coupling capacitance gate-controlled junction field effect transistor according to Embodiment 4 (corresponding to Fig. 3-4) of the present disclosure is shown in Fig. 12 as a structure where a capacitor is connected in series with of the junction field effect transistor. In the diagram, the capacitor is co-coupled with the semiconductor junction capacitor of the JFET to divide the voltage and control the on-off of the JFET.

When the vertical trench coupling capacitance gate-controlled junction field effect transistor of the present disclosure operating, as shown in Fig. 3-4, the voltage will be applied to the coupling capacitance upper electrode 8 and the drain electrode 10. The voltage applied to the coupling capacitance upper electrode 8 will be coupled to gate 6 by the dielectric layer 7. The electric potential coupled to gate 6 will be connected to the second doping type ohmic contact region 3 connected to the source electrode 9 to form the JFET device to control the channel region and further control the on-off of the middle of the channel.

The JFET region will be pinched off in a case where the voltage is applied to make the channel turn off, the channel 5 will be in a depleted state, and the number of the carriers in the channel in the depleted state will be low, and a voltage is applied to the drain electrode 10 at the same time, no current or a very small amount of current passes through the drain 10 to the source electrode 9, due to the channel 5 of the device being depleted and pinched off.

The JFET region will be in a conducted state in a case where the voltage is applied to make the channel turn on, the channel 5 will be in the conducted state connecting from the drain electrode 10 to the source electrode 9 and a voltage is applied to the drain electrode 10 at the same time, the current passes through the drain electrode 10 to the source electrode 9 due to the channel 5 of the device being in a conducted state, and the device works.

The threshold voltage of the vertical trench coupling capacitance gate-controlled junction field effect transistor of the present disclosure can be modulated according to the doping. In a case where the JFET region self-pinch-off by the doping modulating, no voltage is applied to the coupling capacitance upper electrode of the device, under the effect of the own doped self-build electric field, carriers in the channel 5 will be depleted to form a depletion region, and the device will be normally-off. The depletion region can only disappear by applying a positive voltage to the JFET region to form an effective channel to conduct. Affected by the wide band gap characteristic of the silicon carbide, the self-built potential of the PN junction formed by the silicon carbide material is large and can realize a normally-off device structure.

In a case where the JFET region is not self-pinch-off, the device itself has channels and is a normally-on device. According to the operating principle of the JFET, a corresponding voltage should be applied to the controlled region by the JFET to make the channel form into the depletion region and make the device turn off.

The conducting resistance Rsp of the vertical trench coupling capacitance gate-controlled junction field effect transistor of the present disclosure is mainly determined by the resistance R1 of the JFET region and the resistance R2 of the epitaxial layer2, the voltage applied to the drain electrode 10 of the device is divided by the two resistance in series, and the reduction of the resistances of each region has an optimizing effect on the overall conducting resistance of the device.

The advantage of the vertical trench coupling capacitance gate-controlled junction field effect transistor of the present disclosure is described as follows:

The coupling capacitance upper electrode of the vertical trench coupling capacitance gate-controlled junction field effect transistor of the present disclosure adopting the coupling capacitance method has the advantages over the conventional wide band gap metal-oxide-semiconductor field effect transistor:

Fig. 13 is a schematic diagram of the vertical trench coupling capacitance gate-controlled junction field effect transistor according to the embodiment of the present disclosure in a conducted state, illustrating a current path. Fig. 14 is a comparison schematic diagram of the characteristics of the vertical trench coupling capacitance gate-controlled junction field effect transistor according to the present disclosure with the characteristics of the conventional VDMOS device.

As shown in Fig. 13, the dotted lines with arrows show the current paths in a case where the field effect transistor conducting. As shown in Fig. 13, the current paths of the vertical trench coupling capacitance gate-controlled junction field effect transistor of the present disclosure in the case of conduction is located in the body of the device, away from the surface of the semiconductor material, and is not affected by the low mobility of the surface of the material. The performance of the vertical trench coupling capacitance gate-controlled junction field effect transistor of the present disclosure is mainly affected by the thickness of the capacitance dielectric, and the requirement of the electrode work function is low, such as that the coupling capacitance upper electrode is in the polycrystalline silicon material, N-type or P-type polycrystalline silicon, can play the function of capacitive coupling, and the capacitance dielectric can be flexibly selected, such as the conventional oxide or the high-k dielectric material, can also play the function of the capacitive coupling.

Fig. 14 is a comparison schematic diagram of the characteristics of the vertical trench coupling capacitance gate-controlled junction field effect transistor according to the present disclosure with the characteristics of the conventional VDMOS device. As shown in Fig. 14, the vertical trench coupling capacitance gate-controlled junction field effect transistor of the present disclosure has a significant advantage of conducting resistance Rsp compared to the device with the same active region area.

The vertical trench coupling capacitance gate-controlled junction field effect transistor of the present disclosure works by the capacitive coupling principle, the dielectric acts as an insulating layer. In a case where the voltage is applied to the coupling capacitance upper electrode of the device, the electric potential is coupled to gate 6. Due to the gate 6 in a physically floating structure, no current passes through the dielectric layer 7 to the gate 6 mainly controlled by the JFET region of the device. As shown in Fig. 13, the device current conducting paths do not pass through gate 6, and gate 6 has high reliability and has no larger current. under the high drain voltage (the breakdown condition), turning the device off, the epitaxial layer-gate-dielectric layer is the main bearing voltage region. Due to the structure of the semiconductor PN junction of the epitaxial layer-gate, a constant amount of the negative charges exist in the depletion region of the gate, and the electric field lines start from the positive charges in the epitaxial layer and end at the negative charges in the gate, so the high electric field will be shielded at the junction interface of the semiconductor junction. The electric field intensity in the dielectric layer is reduced by the shielding effect of the gate. The typical dielectric electric field intensity is about 2×10⁵ V/cm, lowering than the electric field intensity of the conventional silicon carbide VDMOS device by about an order of magnitude, and the low electric field intensity in the dielectric layer plays a key role in protecting the dielectric layer and improving reliability.

Fig. 15 is a schematic diagram of the vertical trench coupling capacitance gate-controlled junction field effect transistor according to the present disclosure.

Fig. 16 is a potential distribution diagram of the vertical trench coupling capacitance gate-controlled junction field effect transistor according to the present disclosure. As shown in Fig. 16, the potential distribution on the vertical axis and the horizontal position on the horizontal axis.

Where the horizontal dotted line in Fig. 15 shows the horizontal direction. The right portion of the horizontal dotted line on the right of the vertical dotted line in Fig. 15 corresponds to the right portion of the horizontal axis from coordinates 0 in Fig. 16, and the left portion of the horizontal dotted line on the left of the vertical dotted line in Fig. 15 corresponds to the left portion of the horizontal axis from coordinate 0 in Fig. 16.

The current at a high gate voltage of the device of the present disclosure is saturated due to the capacitive coupling effect of the channel. The voltage dividing principle of the coupling capacitance upper electrode of the device of the present disclosure is shown in Fig. 12, the dielectric layer capacitance C_{gate} is formed by the coupling capacitance upper electrode 8, dielectric layer 7, and the gate 6, and the junction capacitance Cₛₑₘ formed by the semiconductor depletion region formed by the gate 6 and the channel 5 are connected in series to control the on-off of the channel by dividing the voltage. In a case where the external gate voltage is Vgs, a voltage shared across the dielectric layer capacitance C_{gate} is Vgs·Cₛₑₘ/(C_{gate}+Cₛₑₘ), the voltage shared across the semiconductor dielectric layer capacitance Cₛₑₘ is Vgs·C_{gate} /(C_{gate}+Cₛₑₘ). The dielectric layer capacitance C_{gate} is a constant value determined by the material and thickness of the dielectric layer 7. In a case where the Vgs begins to increase from 0, the C_{gate} divides the voltage with the dielectric layer junction capacitance C_{gate} formed by the semiconductor self-build electric field. The voltage Vgs applied to the coupling capacitance upper electrode 8 is partly coupled to the semiconductor junction, and the percentage of the voltage coupled to the semiconductor depletion region junction capacitance Cₛₑₘ, i.e., the C_{gate} /(C_{gate}+Cₛₑₘ), is maximum. As the gate voltage Vgs increases and the voltage coupled to the semiconductor depletion region junction capacitance Cₛₑₘ increases, the semiconductor depletion region junction capacitance Cₛₑₘ will be narrowed, the junction capacitance Cₛₑₘ will be larger, and the percentage of voltage coupled to the semiconductor depletion region junction capacitance Cₛₑₘ, i.e., the C_{gate} /(C_{gate}+Cₛₑₘ), will gradually smaller. Until the semiconductor depletion region is narrowed to a constant point, that is, the interface immediately adjacent to the semiconductor junction cannot continue to narrow, the semiconductor depletion region junction capacitance Cₛₑₘ increases to a larger value and remain constant, and will not continue to increase subsequently. At the time, with the voltage Vgs applied to the coupling capacitance upper electrode 8, the electric potential coupled to the gate 6 is maximized and the device saturates.

Figs. 17-1, 17-2, 17-3, 17-4, 17-5, and 17-6 are energy band distribution diagrams for different voltages applied to the coupling capacitance upper electrode 8 of vertical trench coupling capacitance gate-controlled junction field effect transistor according to the present disclosure. The potential distribution on the vertical axis and the horizontal position on the horizontal axis.

Where the vertical dotted line in Fig. 15 shows the vertical direction. The right portion of the horizontal dotted line on the right of the vertical dotted line in Fig. 15 corresponds to the right portion of the horizontal axis from coordinate 0 in Figs. 17-1, 17-2, 17-3, 17-4, 17-5, 17-6, and the left portion of the horizontal dotted line on the left of the vertical dotted line in Fig. 15 corresponds to the left portion of the horizontal axis from coordinate 0 in Figs. 17-1, 17-2, 17-3, 17-4, 17-5, 17-6.

As shown in Figs. 17-1, 17-2, 17-3, 17-4, 17-5, and 17-6, the energy band distribution diagrams for the gate 6, channel 5, and the second doping type ohmic contact region 3 of the vertical trench coupling capacitance gate-controlled junction field effect transistor of the present disclosure shows the relative changes of the conduction band, the valence band, the electrons and the holes Fermi level in each region when the coupling capacitance upper electrode of the device works. As shown in Fig. 17-1, In a case where a voltage Vgs applied to the coupling capacitance upper electrode 8 is 0V, as an example of the channel 5 in the self-depleted state, the Fermi levels within the channel 5 are located in the center of the band gap, the device is in the self-depleted state, and the electron concentration and the hole concentration in the channel 5 are both extremely low. The Fermi levels of the gate 6 and the second doping type ohmic contact region 3 are located near the valence band, the hole concentration is extremely high, and the electron concentration is extremely low. As the voltage Vgs applied to the coupling capacitance upper electrode 8 increases, the distance between the conduction band and the electron Fermi level within the gate 6 and the channel 5 gradually decreases, a low electron concentration appears in the gate 6, the distance between the conduction band and the electron Fermi level in the channel 5 is closer, and an extremely high electron concentration in the channel 5 can be involved in the conductivity to form a conductive channel. Meanwhile, the distance between the valence band and the hole Fermi level in the channel 5 is gradually decreased, and a low concentration of holes appears in the channel 5.

Fig. 18-1 is a carrier concentration distribution diagram in each region of the vertical trench coupling capacitance gate-controlled junction field effect transistor according to the present disclosure, illustrating the hole concentration in the gate 6, the channel 5, and the second doping type ohmic contact region 3 affected by the voltage applied to the coupling capacitance upper electrode 8.

Fig. 18-2 is a carrier concentration distribution diagram in each region of the vertical trench coupling capacitance gate-controlled junction field effect transistor according to the present disclosure, illustrating the electron concentration in the gate 6, the channel 5, and the second doping type ohmic contact region 3 affected by the voltage applied to the coupling capacitance upper electrode 8.

As shown in Figs. 18-1, 18-2, the carrier concentration distribution diagrams in each region of the vertical trench coupling capacitance gate-controlled junction field effect transistor according to the present disclosure, illustrating the electron concentration and the hole concentration in the gate 6, the channel 5, and the second doping ohmic contact region 3 affected by the voltage applied to the coupling capacitance upper electrode 8. In a case where the voltage Vgs applied to the coupling capacitance upper electrode 8 is 0V, the hole concentration within the gate 6 is extremely high and the electron concentration is extremely low, the channel 5 is modulated from doping to the self-depleted state, the electron concentration and the hole concentration are very low. As the voltage Vgs applied to the coupling capacitance upper electrode 8 increases, the voltages coupled to the dielectric layer capacitance and the semiconductor junction capacitance formed by the gate 6 and the channel 5 both increase due to the capacitive coupling principle. As the voltage applied to the semiconductor junction formed by the gate 6 and the channel 5 increases, the depletion region in the channel 5 narrows and changes from the depleted state to the undepleted state, and the electron concentration within the channel 5 increases dramatically to form a conductive channel. Meanwhile, the built-in potential of the semiconductor junction formed by the gate 6 and the channel 5 decreases, part of the electrons within the channel 5 enter the gate 6, the electron concentration within the gate 6 changes from extremely low to low, and part of the holes in the gate 6 enter into the channel 5, the hole concentration within the semiconductor junction formed by the gate 6 and the channel 5 increases.

The voltages are applied to the coupling capacitance upper electrode 8 and the drain electrode 10 of the vertical trench coupling capacitance gate-controlled junction field effect transistor of the present disclosure at the same time. In the case where the voltage applied to the coupling capacitance upper electrode 8 is low, the shut-off current of the device is small. As the voltage applied to the coupling capacitance upper electrode 8 increases, the current of the drain electrode 10 increases. In the case where the voltage applied to the coupling capacitance upper electrode 8 increases to a large value, the semiconductor junction capacitance remains constant and the device saturates. The conventional SiC MOSFET device is not currently saturated when the Vgs is 20V, and the current conducting paths of the device of the present disclosure are away from the surface of the dielectric, which improves the short-circuit resistance of the device.

The vertical trench coupling capacitance gate-controlled junction field effect transistor of the present disclosure has a significant high reliability, high robustness, and manufacturing advantage.

### Embodiment 5

Fig. 3-5 is a schematic diagram of the fifth implementation of a vertical trench coupling capacitance gate-controlled junction field effect transistor according to the present disclosure. The fifth implementation of the vertical trench coupling capacitance gate-controlled junction field effect transistor of the present disclosure differs from the first implementation (i.e., Embodiment 1) in the shapes of the trench, the dielectric layer 7, and the coupling capacitance upper electrode 8.

As shown in Fig. 3-5, the cross section of the trench is in a rectangular shape, correspondingly the dielectric layer 7 only covers the inner bottom of the gate 6 and does not cover the side walls of the gate 6.

The coupling capacitance upper electrode 8 only formed on the dielectric layer 7.

The dielectric layer 7 does not completely cover the side walls of the trench and is formed only at the inner bottom of the trench. The coupling capacitance upper electrode 8 disposed on the dielectric layer. The advantage of the structure is simple and easy to fabricate for the planar process.

The operating principle: the dielectric layer 7 is disposed on the inner bottom of the trench, the coupling capacitance upper electrode 8 is disposed on the dielectric layer 7, the coupling capacitance upper electrode 8 controls the gate 6 with the dielectric layer 7, and further controls the on-off of the JFET region.

Fig. 3-6 is a schematic diagram of the sixth implementation of a vertical trench coupling capacitance gate-controlled junction field effect transistor according to the present disclosure. The sixth implementation of the vertical trench coupling capacitance gate-controlled junction field effect transistor of the present disclosure differs from the second implementation (i.e., Embodiment 2) in the shapes of the trench, the dielectric layer 7, and the coupling capacitance upper electrode 8.

As shown in Fig. 3-6, the cross section of the trench is in rectangular shape, correspondingly the dielectric layer 7 only covers the inner bottom of the gate 6 and does not cover the side walls of the gate 6;
a coupling capacitance upper electrode 8, only formed on the dielectric layer 7.

Fig. 3-7 is a schematic diagram of the seventh implementation of a vertical trench coupling capacitance gate-controlled junction field effect transistor according to the present disclosure. The seventh implementation of the vertical trench coupling capacitance gate-controlled junction field effect transistor of the present disclosure differs from the third implementation (i.e., Embodiment 3) in the shapes of the trench, the dielectric layer 7, and the coupling capacitance upper electrode 8.

As shown in Fig. 3-7, the cross section of the trench is in a rectangular shape, correspondingly the dielectric layer 7 only covers the inner bottom of the gate 6 and does not cover the side walls of the gate 6.
a coupling capacitance upper electrode 8, only formed on the dielectric layer 7.

Fig. 3-8 is a schematic diagram of the eighth implementation of a vertical trench coupling capacitance gate-controlled junction field effect transistor according to the present disclosure. The eighth implementation of the vertical trench coupling capacitance gate-controlled junction field effect transistor of the present disclosure differs from the fourth implementation (i.e., Embodiment 4) in the shapes of the trench, the dielectric layer 7, and the coupling capacitance upper electrode 8.

As shown in Fig. 3-8, the cross section of the trench is in a rectangular shape, correspondingly the dielectric layer 7 only covers the inner bottom of the gate 6 and not cover the side walls of the gate 6.

The coupling capacitance upper electrode 8 only formed on the dielectric layer 7.

Fig. 3-9 is a schematic diagram of the ninth implementation of a vertical trench coupling capacitance gate-controlled junction field effect transistor according to the present disclosure. A metal silicide layer 11 is shown in Fig. 3-9. As shown in Fig 3-9, the metal silicide layer 11, formed between the gate 6 and the dielectric layer 7.

The metal silicide layer 11 (referred to as the silicide layer) is under the dielectric layer 7 and the coupling capacitance upper electrode 8, that is, the metal silicide layer 11 can be between the dielectric layer 7 and the gate 6. Thus, the metal silicide layer 11 under the dielectric layer 7 is a metal layer, and the electric field is uniformly distributed inside the metal layer, optimizing the electric field of the gate 6 and improving the reliability of the device.

Fig. 3-10 is a schematic diagram of the tenth implementation of a vertical trench coupling capacitance gate-controlled junction field effect transistor according to the present disclosure. A metal silicide layer 11 is shown in Fig. 3-10. As shown in Fig 3-10, the metal silicide layer 11 formed between the gate 6 and the dielectric layer 7.

### Embodiment 6

One of the manufacturing methods of the vertical trench coupling capacitance gate-controlled junction field effect transistor according to the present disclosure comprises:
forming an epitaxial layer 2 of the first doping type on the substrate 1 of the first doping type; and
forming a plurality of repeating units; where the step of forming each of the plurality of repeating units comprises:
forming two source regions 4 of the first doping type inside the epitaxial layer and spaced apart in the lateral direction;
forming a trench downwardly from an upper surface of the epitaxial layer 2 and disposed between the two source regions 4 of the first doping type;
forming a gate 6 of the second doping type on an inner wall and a bottom of the trench;
forming a dielectric layer 7, at least formed on the inner bottom of the gate 6; and
forming a coupling capacitance upper electrode 8, formed on the dielectric layer 7.

In the embodiment, forming each of the plurality of the repeating units further comprises:
forming two channels 5 of the first doping type, disposed below the two source regions 4 respectively.

In the embodiment, forming each of the plurality of the repeating units further comprises:
forming two channels 5 of the first doping type, disposed below the two source regions 4 respectively; and
forming two second doping type ohmic contact regions 3, disposed outside the two source regions 4 respectively.

In the descriptions of the disclosure and the embodiments thereof, it is to be understood that orientation or position relationships indicated by terms "top", "bottom", "height", and the like are orientation or position relationships shown in the drawings, are adopted not to indicate or imply that indicated devices or components must be in specific orientations or structured and operated in specific orientations but only to conveniently describe the disclosure and simplify descriptions, and thus should not be understood as limits to the disclosure.

In the disclosure and the embodiments thereof, unless otherwise definitely specified and limited, terms "arrange", "mount", "mutually connect", "connect", "fix" and the like should be broadly understood. For example, the terms may refer to fixed connection and may also refer to detachable connection or integration. The terms may refer to mechanical connection, may also refer to electrical connection, and may also refer to communication. The terms may refer to direct mutual connection, may also refer to indirect connection through a medium, and may refer to communication in two components or an interaction relationship of the two components. Those having ordinary skill in the art may understand specific meanings of the above terms in the embodiments of the present disclosure according to specific situations.

In the disclosure and the embodiments thereof, unless otherwise expressly stated and defined, the state that a first feature is "above" or "below" a second feature may include that the first feature directly contacts with the second feature, or may include that the first and second features contact not directly but through another feature therebetween. Moreover, the state that the first feature is "above", "over" and "on" the second feature may include that the first feature is over and above the second feature, or only represent that a horizontal height of the first feature is greater than that of the second feature. The state that the first feature is "below", "under" and "underneath" the second feature may include that the first feature is under and below the second feature, or only represents that the horizontal height of the first feature is less than that of the second feature.

The above disclosure provides many different implementation modes or examples to implement different structures of the disclosure. To simplify the disclosure of the disclosure, components and arrangements in specific examples are described above. Of course, they are merely examples and not intended to limit the disclosure. In addition, reference numbers and/or reference letters in the disclosure can be repeated in different examples, and such repetitions are for purposes of simplicity and clarity, and do not indicate relationships between the discussed implementation modes and/or arrangements. Moreover, the disclosure provides examples of various specific processes and materials, but those of ordinary skill in the art can realize disclosures of other processes and/or uses of other materials.

Although some optional embodiments of the disclosure have been described, those skilled in the art, once learning about basic creative concepts, may make other variations and modifications to these embodiments. Therefore, it is intended that the appended claims are explained to include the optional embodiments and all the variations and modifications falling within the scope of the disclosure.

It is apparent that those skilled in the art may make various modifications and transformations to the disclosure without departing from the spirit and scope of the disclosure. Therefore, if these modifications and transformations of the disclosure fall within the scopes of the claims of the disclosure and equivalent technologies thereof, the disclosure is also intended to include these modifications and transformations.

## Claims

1. A vertical trench capacitance coupling gate-controlled junction gate field effect transistor, **characterized in that**, comprising: a substrate (1) of a first doping type, an epitaxial layer (2) of the first doping type, and a plurality of repeating units disposed adjacently;
wherein the epitaxial layer (2) is disposed on the substrate (1), the substrate (1) is served as a drain region, and each of the repeating unit comprises:
two source regions (4) of the first doping type, formed inside the epitaxial layer (2) and spaced apart in the lateral direction;
a trench formed downwardly from an upper surface of the epitaxial layer (2) and disposed between the two source regions (4) of the first doping type;
a gate (6) of the second doping type, formed on an inner wall and a bottom of the trench, wherein the gate (6) is in a floating state;
a dielectric layer (7), at least formed on the inner bottom of the gate (6); and
a coupling capacitance upper electrode (8), formed on the dielectric layer (7);
wherein the gate (6) is indirectly controlled by the coupling capacitance upper electrode (8) spaced with the dielectric layer (7).

2. The vertical trench capacitance coupling gate-controlled junction gate field effect transistor according to claim 1, wherein a JFET region formed by the gates (6) of the second doping type in the adjacent repeating units and regions of the epitaxial layer between the adjacent gates (6) of the second doping type, and the gates (6) in the JFET region are indirectly controlled by the coupling capacitance upper electrode (8) spaced with the dielectric layer (7).

3. The vertical trench coupling capacitance gate-controlled junction field effect transistor according to claim 1, comprising:
two channels (5) of the first doping type, disposed below the two source regions (4) respectively;
wherein a JFET region is formed by the gate (6) of the second doping type, the channels (5) of the first doping type, and another gate (6) of the second doping type in the adjacent repeating unit, and the gates (6) in the JFET region are indirectly controlled by the coupling capacitance upper electrode (8) spaced with the dielectric layer (7).

4. The vertical trench coupling capacitance gate-controlled junction field effect transistor according to any one of claims 1 to 3, further comprising:
two second doping type ohmic contact regions (3), disposed outside the two source regions (4) respectively;
wherein a JFET region formed by the gate (6) of the second doping type, a region of the epitaxial layer (2) between the gate (6) of the second doping type and the second doping type ohmic contact region (3), and the second doping type ohmic contact region (3), and the gate (6) in the JFET region is indirectly controlled by the coupling capacitance upper electrode (8) spaced with the dielectric layer (7).

5. The vertical trench coupling capacitance gate-controlled junction field effect transistor according to claims 1 or 2, further comprising:
two channels (5) of the first doping type, disposed below the two source regions (4) respectively; and
two second doping type ohmic contact regions (3), respectively disposed outside the two source regions (4) and the channel (5);
wherein a JFET region is formed by the gate (6) of the second doping type, the channel (5) of the first doping type, and second doping type ohmic contact regions (3), and the gate (6) in the JFET region is indirectly controlled by the coupling capacitance upper electrode (8) spaced with the dielectric layer (7); and
wherein the gate (6), the channel (5), the source region (4), and the second doping type ohmic contact region (3) are formed inside the epitaxial layer (2).

6. The vertical trench coupling capacitance gate-controlled junction field effect transistor according to any one of claims 1 to 5, further comprising:
a drain electrode (10), disposed on a lower surface of the substrate (1); and
two source electrodes (9), formed on the two source regions (4) respectively;
wherein internal conducting paths within the substrate (1) and the epitaxial layer (2) from a drain electrode to two source electrodes are formed by the substrate (1) of the first doping type, the epitaxial layer (2) of the first doping type, and the two source regions (4) of the first doping type.

7. The vertical trench coupling capacitance gate-controlled junction field effect transistor according to any one of claims 1 to 6, wherein the trench is in a U-shape, the dielectric layer (7) covers a coupling capacitance upper electrode space surrounded by an inner wall of the gate (6), the dielectric layer (7) covers a top of the gate, and the coupling capacitance upper electrode (8) is formed in the coupling capacitance upper electrode space; or
wherein a cross section of the trench is in a rectangular shape, the dielectric layer (7) covers an inner bottom of the gate (6), and the coupling capacitance upper electrode (8) is formed on the dielectric layer (7).

8. The vertical trench coupling capacitance gate-controlled junction field effect transistor according to any one of claims 1 to 7, wherein by controlling a doping of the two gates (6) of the second doping type in the two adjacent repeating units, in a case where a voltage applied to the coupling capacitance upper electrode (8) is 0V, a region between the two gates (6) of the second doping type in the two adjacent repeating units is in a depleted state, and the vertical trench coupling capacitance gate-controlled junction field effect transistor is a normally-off device; or
wherein by controlling a doping of the two gates (6) of the second doping type in the two adjacent repeating units, in a case where a voltage applied to the coupling capacitance upper electrode (8) is 0V, a region between the two gates (6) of the second doping type in the two adjacent repeating units is in a conducted state and the vertical trench coupling capacitance gate-controlled junction field effect transistor is a normally-on device; or
wherein by controlling a doping of the gate (6) of the second doping type and the second doping type ohmic contact region (3), in a case where a voltage applied to the coupling capacitance upper electrode (8) is 0V, a region between the gate (6) of the second doping type and the second doping type ohmic contact region (3) is in a depleted state and the vertical trench coupling capacitance gate-controlled junction field effect transistor is a normally-off device; or
wherein by controlling a doping of the gate (6) of the second doping type and the second doping type ohmic contact region (3), in a case where a voltage applied to the coupling capacitance upper electrode (8) is 0V, a region between the gate (6) of the second doping type and the second doping type ohmic contact region (3) is in a conducted state and the vertical trench coupling capacitance gate-controlled junction field effect transistor is a normally-on device.

9. The vertical trench coupling capacitance gate-controlled junction field effect transistor according to any one of claims 1 to 8, wherein the substrate is selected from at least one of silicon carbide substrate, silicon substrate, diamond substrate, or potassium oxide substrate;
the dielectric layer is made of high dielectric constant material; or
the coupling capacitance upper electrode (8) is selected from at least one of polycrystalline silicon electrode or metal electrode.

10. The vertical trench coupling capacitance gate-controlled junction field effect transistor according to any one of claims 1 to 9, further comprising:
a metal silicide layer (11), formed between the gate (6) and the dielectric layer (7).

11. The vertical trench coupling capacitance gate-controlled junction field effect transistor according to any one of claims 1 to 10, wherein a doping concentration of the gate (6) is larger than or equal to 1×10¹⁶cm⁻³.

12. The vertical trench coupling capacitance gate-controlled junction field effect transistor according to any one of claims 3 to 11, wherein a doping concentration of the channel (5) is larger than a doping concentration of the substrate (1) and the epitaxial layer (2).

13. A manufacturing method of a vertical trench coupling capacitance gate-controlled junction field effect transistor, **characterized in that**, comprising:
forming an epitaxial layer (2) of a first doping type on a substrate (1) of the first doping type; and
forming a plurality of repeating units;
wherein the step of forming each of the plurality of repeating units comprises:
forming two source regions (4) of the first doping type inside the epitaxial layer (2) and spaced apart in the lateral direction;
forming a trench downwardly from an upper surface of the epitaxial layer (2) and disposed between the two source regions (4) of the first doping type;
forming a gate (6) of the second doping type on an inner wall and a bottom of the trench;
forming a dielectric layer (7) at least on the inner bottom of the gate (6); and
forming a coupling capacitance upper electrode (8) on the dielectric layer (7).

14. The manufacturing method of the vertical trench coupling capacitance gate-controlled junction field effect transistor according to claim 13, wherein the step of forming each of the plurality of repeating units further comprises:
forming two channels (5) of the first doping type, disposed below the two source regions (4) respectively.

15. The manufacturing method of the vertical trench coupling capacitance gate-controlled junction field effect transistor according to claim 13, wherein the step of forming each of the plurality of repeating units further comprises:
forming two channels (5) of the first doping type, disposed below the two source regions (4) respectively; and
forming two second doping type ohmic contact regions (3) disposed outside the two source regions (4) respectively.
